(19) Europäisches Patentamt
European Patent Office
Office européen des brevets

(11) **EP 4 148 499 A1**

(12) **EUROPEAN PATENT APPLICATION**

(43) Date of publication:
**15.03.2023 Bulletin 2023/11**

(21) Application number: **21195866.5**

(22) Date of filing: **09.09.2021**

(51) International Patent Classification (IPC):
**G03F 1/84** *(2012.01)*      **G01N 21/956** *(2006.01)*
**G03F 7/20** *(2006.01)*      **G06T 7/00** *(2006.01)*

(52) Cooperative Patent Classification (CPC):
**G03F 1/84; G01N 21/956; G03F 7/7065;**
**G06T 7/0004;** G06T 2207/10061; G06T 2207/30148

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **VAN LARE, Marie-Claire**
  **5500 AH Veldhoven (NL)**
• **WIELAND, Marco, Jan-Jaco**
  **5500 AH Veldhoven (NL)**

(74) Representative: **ASML Netherlands B.V.**
**Corporate Intellectual Property**
**P.O. Box 324**
**5500 AH Veldhoven (NL)**

(54) **PATTERNING DEVICE DEFECT DETECTION SYSTEMS AND METHODS**

(57)    Since a mask check wafer can utilize a different process than a production wafer, a high-contrast illumination setting with lower pupil fill ratio (PFR) that leads to a reduction of the productivity of the scanner can be utilized. By selecting a high-contrast illumination setting, which is different than that used on a production wafer, an improved ratio of particle printability to stochastic defects can be achieved. In combination, or instead higher dose resist can be utilized. This allows longer exposure of the wafer, such that the impact of photon shot noise is reduced, also resulting in an improved ratio of particle printability to stochastic defects. As a result, the particle printability can be enhanced further without leading to an excessive amount of stochastic defects. Because of this, the number of sites, and therefore the throughput, of a charged particle inspection and analysis can be significantly improved.

**FIG. 7**

**Description**

TECHNICAL FIELD

The present disclosure relates generally to enhancing patterning device defect detection by charged particle or optical inspection associated with semiconductor manufacturing processes.

BACKGROUND

In manufacturing processes of integrated circuits (ICs), unfinished or finished circuit components are inspected to ensure that they are manufactured according to design and are free of defects. Inspection systems utilizing optical microscopes or charged particle (e.g., electron) beam microscopes, such as a scanning electron microscope (SEM) can be employed. As the physical sizes of IC components continue to shrink, and their structures continue to become more complex, accuracy and throughput in defect detection and inspection become more important. The overall image quality depends on a combination of high secondary-electron and backscattered-electron signal detection efficiencies, among others. Backscattered electrons have higher emission energy to escape from deeper layers of a sample, and therefore, their detection may be desirable for imaging of complex structures such as buried layers, nodes, high-aspect-ratio trenches or holes of 3D NAND devices. For applications such as overlay metrology, it may be desirable to obtain high quality imaging and efficient collection of surface information from secondary electrons and buried layer information from backscattered electrons, simultaneously, highlighting a need for using multiple electron detectors in a SEM. Although multiple electron detectors in various structural arrangements may be used to maximize collection and detection efficiencies of secondary and backscattered electrons individually, the combined detection efficiencies remain low, and therefore, the image quality achieved may be inadequate for high accuracy and high throughput defect inspection and metrology of two-dimensional and three-dimensional structures.

SUMMARY

A mask is used to expose a wafer, and the wafer is inspected to locate a defect on the mask (by virtue of the defect being repeatedly printed on the wafer). Some mask defects are not reliably printed. For example, a 60nm particle may be printed only about 10% of the time, reducing the reliability and throughput of detecting such a mask defect by inspecting a wafer exposed with the defective mask. As a result, many identical locations need to be inspected, resulting in reduced throughput.

According to an embodiment, there is provided a method for detecting a defect in a patterning device. The method comprises inspecting a patterned substrate with a charged particle inspection system. The patterned substrate is produced using the patterning device and by modulating patterning parameters compared to patterning parameters used during a regular production patterning process. Modulating the patterning parameters enhances a patternability of the defect onto the patterned substrate. The method comprises detecting a defect in the patterned substrate associated with the enhanced patternability of the defect in the patterning device, and detecting the defect in the patterning device based on the defect in the patterned substrate.

In some embodiments, modulating the patterning parameters enhances the patternability of the defect onto the patterned substrate relative to a patternability of the defect in the regular production patterning process, and balances the enhanced patternability with a quantity of patterned defects in the patterned substrate associated with the modulated patterning parameters. Modulating the patterning parameters is performed without regard for the patterning productivity of the patterned substrate (e.g., a mask check wafer).

In some embodiments, the method comprises repeating the inspection at candidate defect areas on the patterned substrate in multiple fields to determine which defects repeat across the patterned substrate and thus were enhanced by modulating the patterning parameters.

In some embodiments, modulating the patterning parameters comprises coating the substrate with a different, higher dose resist compared to a regular production patterning process resist.

In some embodiments, modulating the patterning parameters comprises varying a dose or focus of exposure illumination associated with the regular production patterning process.

In some embodiments, modulating the patterning parameters comprises coating the substrate with a different resist compared to a regular production patterning process resist and varying the dose of the exposure illumination associated with the regular production patterning process, and wherein varying the dose comprises increasing the dose relative to a dose used for the regular production patterning process.

In some embodiments, modulating the patterning parameters comprises providing higher contrast illumination for patterning compared to illumination provided during the regular production patterning process.

In some embodiments, modulating the patterning parameters comprises varying a pupil fill ratio (PFR) associated with the regular patterning process.

In some embodiments, the PFR is varied to less than 20%, which causes an illuminator efficiency of the regular patterning process to be less than 100%.

In some embodiments, the patterning device is a mask, and the regular patterning process is a semiconductor manufacturing process.

In some embodiments, the charged particle inspection system is a scanning electron microscope (SEM).

In some embodiments, modulating the patterning parameters to enhance the patternability of the defect in the patterning device onto the patterned substrate comprises modulating the patterning parameters to enhance a likelihood that the defect in the patterning device is patterned onto the patterned substrate relative to a likelihood of patterning the defect in the regular production patterning process.

In some embodiments, the patterned defects in the patterned substrate associated with the modulated patterning parameters comprise stochastic defects.

In some embodiments, the patterned substrate is produced with a lithography system associated with the regular production patterning process or a separate lithography system.

In some embodiments, the patterned substrate is a patterned semiconductor wafer and the defect in the patterning device comprises a particle on the patterning device.

In some embodiments, the patterned substrate produced using the patterning device and by modulating patterning parameters compared to patterning parameters used during a regular production patterning process is produced using a pattern design and patterning device that are the same as a pattern design and a patterning device used in the regular production patterning process.

According to another embodiment, there is provided a method for detecting a defect in a patterning device. The method comprises inspecting a patterned substrate with an inspection system. The patterned substrate is produced using the patterning device and by modulating patterning parameters compared to patterning parameters used during a regular production patterning process. Modulating the patterning parameters enhances a patternability of the defect onto the patterned substrate. The method comprises detecting a defect in the patterned substrate associated with the enhanced patternability of the defect in the patterning device. The method comprises detecting the defect in the patterning device based on the defect in the patterned substrate.

According to another embodiment, there is provided a method for enhancing patterning of a defect in a patterning device onto a substrate. The method comprises modulating patterning parameters of a regular production patterning process. Modulating the patterning parameters enhances a patternability of the defect in the patterning device onto the substrate compared to a patternability of the defect in the regular production patterning process. The method comprises patterning the defect in the patterning device onto the substrate using modulated patterning parameters. After patterning with the modulated patterning parameters, and because of the enhanced patternability of the defect balanced with the quantity of patterned defects associated with the modulated patterning parameters, the substrate is configured for inspection with a charged particle inspection system.

According to another embodiment, there is provided a method to detect a defect in a mask used in a semiconductor manufacturing process. The detection is performed on a defect enhanced non-production patterned semiconductor wafer without regard for the patterning productivity of the patterned substrate (e.g., a mask check wafer). The method comprises inspecting the patterned semiconductor wafer with a charged particle inspection system. The patterned semiconductor wafer is produced using the mask and by modulating patterning parameters compared to patterning parameters used during a regular semiconductor manufacturing patterning process. The method comprises modulating the patterning parameters is configured to enhance a patternability of the defect in the mask onto the patterned semiconductor wafer and balance the enhanced patternability with a quantity of patterned defects in the patterned semiconductor wafer associated with the modulated patterning parameters. The method comprises detecting a defect in the patterned semiconductor wafer associated with the enhanced patternability of the defect in the mask. The method comprises detecting the defect in the mask based on the defect in the patterned semiconductor wafer.

According to other embodiments, corresponding systems, or computer readable media storing machine readable instructions, configured to perform (or cause one or more processors to perform) one or more of the operations described above, are provided.

Other advantages of the embodiments of the present disclosure will become apparent from the following description taken in conjunction with the accompanying drawings, which set forth, by way of illustration and example, certain example embodiments.

BRIEF DESCRIPTION OF THE DRAWINGS

The accompanying drawings, which are incorporated in and constitute a part of the specification, illustrate one or more embodiments and, together with the description, explain these embodiments. Embodiments will now be described, by way of example only, with reference to the accompanying schematic drawings in which corresponding reference symbols indicate corresponding parts, and in which:

Figure 1 is a schematic diagram of a lithographic projection apparatus, consistent with embodiments of the present disclosure.
Figure 2 depicts a schematic overview of a lithographic cell, consistent with embodiments of the present disclosure.
Figure 3 depicts a schematic representation of holistic lithography, representing a cooperation between three technologies to optimize semiconductor manufacturing, consistent with embodiments of the present disclosure.
Figure 4 schematically depicts an embodiment of a charged particle (e.g., an electron beam) inspection apparatus, consistent with embodiments of the present disclosure.

Figure 5 schematically illustrates another embodiment of an inspection apparatus, consistent with embodiments of the present disclosure.

Figure 6 illustrates a method for detecting a defect in a patterning device, consistent with embodiments of the present disclosure.

Figure 7 illustrates a generalized example of patterning device defects that are not patterned onto substrate, while a stochastic defect is patterned, consistent with embodiments of the present disclosure.

Figure 8 generally illustrates defect printability versus particle size, consistent with embodiments of the present disclosure.

Figure 9A illustrates a method for enhancing patterning of a defect in a patterning device onto a substrate, consistent with embodiments of the present disclosure.

Figure 9B illustrates another method for enhancing patterning of a defect in a patterning device onto a substrate, consistent with embodiments of the present disclosure.

Figure 10 is a block diagram of an example computer system, consistent with embodiments of the present disclosure.

Figure 11 is schematic diagram of another lithographic projection apparatus, consistent with embodiments of the present disclosure.

Figure 12 is a more detailed view of components of a lithographic projection apparatus (e.g., the lithographic projection apparatus illustrated in Figure 1 or Figure 11), consistent with embodiments of the present disclosure.

Figure 13 is a detailed view of the source collector module of a lithographic projection apparatus, consistent with embodiments of the present disclosure.

DETAILED DESCRIPTION

Electronic devices are constructed of circuits formed on a piece of silicon called a substrate or a wafer. Many circuits may be formed as a repeating pattern of features together on the same piece of silicon, and are called integrated circuits or ICs. The size of these circuits has decreased dramatically so that many more of them can fit on the substrate. For example, an IC chip in a smart phone can be as small as a thumbnail and yet may include over 2 billion transistors, the size of each transistor being less than 1/1000th the size of a human hair.

Making these extremely small ICs is a complex, time-consuming, and expensive process, often involving hundreds of individual steps. Errors in even one step have the potential to result in defects in the finished IC, thereby rendering it useless. Thus, one goal of the manufacturing process is to avoid such defects to maximize the number of functional ICs made in the process, that is, to improve the overall yield of the process.

One component of improving yield is monitoring the chip making process to ensure that it is producing a sufficient number of functional integrated circuits. One way to monitor the process is to inspect the chip circuit structures at various stages of their formation. Inspection can be carried out using a scanning electron microscope (SEM). An SEM can be used to image these extremely small structures, in effect, taking a "picture" of the structures. The image can be used to determine if the structure was formed properly and also if it was formed in the proper location. If the structure is defective, then the process can be adjusted so the defect is less likely to recur. A second way to monitor the process is to inspect the mask used to expose the integrated circuit during the lithography process to look for mask defects. Sometimes, a mask check wafer (e.g., a separate, non-production wafer, used for inspection) is used to inspect the mask, such as by looking for repeating defects on a wafer that are caused by a mask defect.

A mask check wafer can utilize a different patterning process than a production wafer (which uses a regular production patterning process). Because of this, different patterning process parameters that lead to a reduction of the productivity of the patterning system can be utilized. An example of a different patterning parameter includes a high-contrast illumination setting (for the light used to pattern the chip circuit onto the wafer) with a lower pupil fill ratio (PFR) (e.g., below 20%). By selecting a high-contrast illumination setting, which is different than the contrast setting used on a production wafer, an improved ratio of patterning device defect (e.g., a particle on the mask) printability to stochastic defects can be achieved. Stochastic defects are defects caused by parameters of the patterning process (e.g., the high-contrast illumination or other parameters). In combination, or instead, a higher dose resist can be utilized. This allows longer exposure of the substrate, such that the impact of photon shot noise or other variables is reduced, also resulting in an improved ratio of defect printability to stochastic defects. As a result, the defect printability can be enhanced by using conditions other than best energy / best focus without leading to an excessive amount of stochastic defects. Because of this, the number of sites, and therefore the throughput, of a charged particle inspection and analysis can be significantly improved.

Embodiments of the present disclosure are described in detail with reference to the drawings, which are provided as illustrative examples of the disclosure so as to enable those skilled in the art to practice the disclosure. The figures and examples below are not meant to limit the scope of the present disclosure to a single embodiment, but other embodiments are possible by way of interchange of some or all of the described or illustrated elements. Where certain elements of the present disclosure can be partially or fully implemented using known components, only those portions of such known components that are necessary for an understanding of the present disclosure will be described, and detailed de-

7 EP 4 148 499 A1 8

scriptions of other portions of such known components will be omitted so as not to obscure the disclosure. Embodiments described as being implemented in software should not be limited thereto, but can include embodiments implemented in hardware, or combinations of software and hardware, and vice-versa, as will be apparent to those skilled in the art, unless otherwise specified herein. In the present specification, an embodiment showing a singular component should not be considered limiting; rather, the disclosure is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. The present disclosure encompasses present and future known equivalents to the known components referred to herein by way of illustration.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display (LCD) panels, thin-film magnetic heads, etc. The skilled artisan will appreciate that, in the context of such alternative applications, any use of the terms "reticle", "wafer" or "die" in this text should be considered as interchangeable with the more general terms "mask", "substrate" and "target portion", respectively.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "projection optics," as used herein, should be broadly interpreted as encompassing various types of optical systems, including refractive optics, reflective optics, apertures and catadioptric optics, for example. The term "projection optics" may also include components operating according to any of these design types for directing, shaping, or controlling the projection beam of radiation, collectively or singularly. The term "projection optics" may include any optical component in the lithographic projection apparatus, no matter where the optical component is located on an optical path of the lithographic projection apparatus. Projection optics may include optical components for shaping, adjusting or projecting radiation from the source before the radiation passes the (e.g., semiconductor) patterning device, or optical components for shaping, adjusting or projecting the radiation after the radiation passes the patterning device. The projection optics generally exclude the source and the patterning device.

A (e.g., semiconductor) patterning device can comprise, or can form, one or more design layouts. The design layout can be generated utilizing CAD (computer-aided design) programs, this process often being referred to as EDA (electronic design automation). Most CAD programs follow a set of predetermined design rules in order to create functional design layouts/patterning devices. These rules are set by processing and design limitations. For example, design rules define the space tolerance between devices (such as gates, capacitors, etc.) or interconnect lines, so as to ensure that the devices or lines do not interact with one another in an undesirable way. The design rules may include or specify specific parameters, limits on ranges for parameters, or other information. One or more of the design rule limitations or parameters may be referred to as a "critical dimension" (CD). A critical dimension of a device can be defined as the smallest width of a line or hole or the smallest space between two lines or two holes, or other features. Thus, the CD determines the overall size and density of the designed device. One of the goals in device fabrication is to faithfully reproduce the original design intent on the substrate (via the patterning device).

The term "mask" or "patterning device" as employed in this text may be broadly interpreted as referring to a generic semiconductor patterning device that can be used to endow an incoming radiation beam with a patterned cross-section, corresponding to a pattern that is to be created in a target portion of the substrate; the term "light valve" can also be used in this context. Besides the classic mask (transmissive or reflective; binary, phase-shifting, hybrid, etc.), examples of other such patterning devices include a programmable mirror array and a programmable LCD array.

An example of a programmable mirror array can be a matrix-addressable surface having a viscoelastic control layer and a reflective surface. The basic principle behind such an apparatus is that (for example) addressed areas of the reflective surface reflect incident radiation as diffracted radiation, whereas unaddressed areas reflect incident radiation as undiffracted radiation. Using an appropriate filter, the said undiffracted radiation can be filtered out of the reflected beam, leaving only the diffracted radiation behind; in this manner, the beam becomes patterned according to the addressing pattern of the matrix-addressable surface. The required matrix addressing can be performed using suitable electronic means. An example of a programmable LCD array is given in U.S. Patent No. 5,229,872, which is incorporated herein by reference.

As used herein, the term "patterning process" generally means a process that creates an etched substrate by the application of specified patterns of light as part of a lithography process. However, "patterning process" can also include (e.g., plasma) etching, as many of the features described herein can provide benefits to forming printed patterns using etch (e.g., plasma) processing.

As used herein, the term "pattern" means an idealized pattern that is to be etched on a substrate (e.g., wafer).

5

As used herein, a "printed pattern" means the physical pattern on a substrate that was etched based on a target pattern. The printed pattern can include, for example, troughs, channels, depressions, edges, or other two and three dimensional features resulting from a lithography process.

As used herein, the term "prediction model", "process model", "electronic model", or "simulation model" (which may be used interchangeably) means a model that includes one or more models that simulate a patterning process. For example, a model can include an optical model (e.g., that models a lens system/projection system used to deliver light in a lithography process and may include modelling the final optical image of light that goes onto a photoresist), a resist model (e.g., that models physical effects of the resist, such as chemical effects due to the light), an optical proximity correction (OPC) model (e.g., that can be used to make target patterns and may include sub-resolution resist features (SRAFs), etc.), an etch (or etch bias) model (e.g., that simulates the physical effects of an etching process on a printed wafer pattern), or other models.

As used herein, the term "calibrating" means to modify (e.g., improve or tune) or validate something, such as a model.

A patterning system may be a system comprising any or all of the components described above, plus other components configured to performing any or all of the operations associated with these components. A patterning system may include a lithographic projection apparatus, a scanner, systems configured to apply or remove resist, etching systems, or other systems, for example.

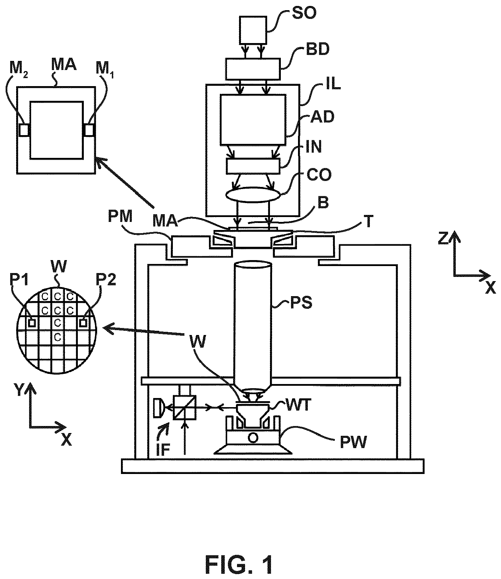

As an introduction, Figure 1 is a schematic diagram of a lithographic projection apparatus, according to an embodiment. The lithographic projection apparatus can include an illumination system IL, a first object table T, a second object table WT, and a projection system PS. Illumination system IL, can condition a beam B of radiation. In this example, the illumination system also comprises a radiation source SO. First object table (e.g., a patterning device table) T can be provided with a patterning device holder to hold a patterning device MA (e.g., a reticle), and connected to a first positioner to accurately position the patterning device with respect to item PS. Second object table (e.g., a substrate table) WT can be provided with a substrate holder to hold a substrate W (e.g., a resist-coated silicon wafer), and connected to a second positioner to accurately position the substrate with respect to item PS. Projection system (e.g., which includes a lens) PS (e.g., a refractive, catoptric or catadioptric optical system) can image an irradiated portion of the patterning device MA onto a target portion C (e.g., comprising one or more dies) of the substrate W. Patterning device MA and substrate W may be aligned using patterning device alignment marks M1, M2 and substrate alignment marks PI, P2, for example.

As depicted, the apparatus can be of a transmissive type (i.e., has a transmissive patterning device). However, in general, it may also be of a reflective type, for example (with a reflective patterning device). The apparatus may employ a different kind of patterning device for a classic mask; examples include a programmable mirror array or LCD matrix.

The source SO (e.g., a mercury lamp or excimer laser, LPP (laser produced plasma) EUV source) produces a beam of radiation. This beam is fed into an illumination system (illuminator) IL, either directly or after having traversed conditioning means, such as a beam expander, or beam delivery system BD (comprising directing mirrors, the beam expander, etc.). for example. The illuminator IL may comprise adjusting means AD for setting the outer or inner radial extent (commonly referred to as σ-outer and σ-inner, respectively) of the intensity distribution in the beam. In addition, it will generally comprise various other components, such as an integrator IN and a condenser CO. In this way, the beam B impinging on the patterning device MA has a desired uniformity and intensity distribution in its cross-section.

In some embodiments, source SO may be within the housing of the lithographic projection apparatus (as is often the case when source SO is a mercury lamp, for example), but that it may also be remote from the lithographic projection apparatus. The radiation beam that it produces may be led into the apparatus (e.g., with the aid of suitable directing mirrors), for example. This latter scenario can be the case when source SO is an excimer laser (e.g., based on KrF, ArF or F2 lasing), for example.

The beam B can subsequently intercept patterning device MA, which is held on a patterning device table T. Having traversed patterning device MA, the beam B can pass through the lens PL, which focuses beam B onto target portion C of substrate W. With the aid of the second positioning means (and interferometric measuring means IF), the substrate table WT can be moved accurately, e.g. to position different target portions C in the path of beam B. Similarly, the first positioning means can be used to accurately position patterning device MA with respect to the path of beam B, e.g., after mechanical retrieval of the patterning device MA from a patterning device library, or during a scan. In general, movement of the tables T, WT can be realized with the aid of a long-stroke module (coarse positioning) and a short-stroke module (fine positioning). However, in the case of a stepper (as opposed to a step-and-scan tool), patterning device table T may be connected to a short stroke actuator, or may be fixed.

The depicted tool can be used in two different modes, step mode and scan mode. In step mode, patterning device table T is kept essentially stationary, and an entire patterning device image is projected in one operation (i.e., a single "flash") onto a target portion C. Substrate table WT can be shifted in the x or y directions so that a different target portion C can be irradiated by beam B. In scan mode, essentially the same scenario applies, except that a given target portion C is not exposed in a single "flash." Instead, patterning device table T is movable in a given direction (e.g., the "scan direction", or the "y" direction) with a speed v, so that projection beam B is caused to scan over a patterning device image. Concurrently, substrate table WT is simultaneously moved in the same or opposite direction at a speed $V = Mv$, in which M is the magnification of the lens (typically, M = 1/4 or 1/5). In this manner, a relatively large target portion C can be exposed, without having to compromise on resolution.

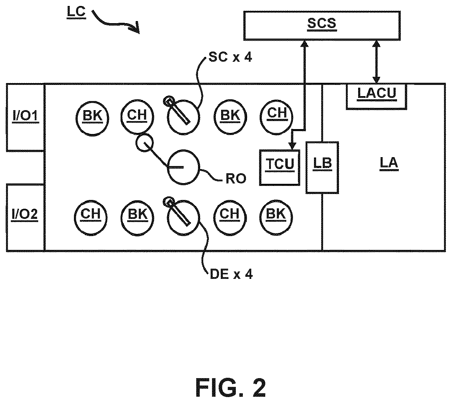

Figure 2 depicts a schematic overview of a lithographic cell LC. As shown in Figure 2, a lithographic projection apparatus (shown in Figure 1 and illustrated as lithographic apparatus LA in Figure 2) may form part of lithographic cell LC, also sometimes referred to as a lithocell or (litho)cluster, which often also includes apparatus to perform pre- and post-exposure processes on a substrate W. Conventionally, these include spin coaters SC configured to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W (Figure 1) exposed by the lithographic apparatus LA to be exposed correctly and consistently, it is desirable to inspect substrates to measure properties of patterned structures, such as feature edge placement, overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W (Figure 1), and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties using an actual substrate (e.g., a charged particle - SEM - image of a wafer pattern) or an image of an actual substrate, on a latent image (image in a resist layer after the exposure), on a semi-latent image (image in a resist layer after a post-exposure bake step PEB), on a developed resist image (in which the exposed or unexposed parts of the resist have been removed), on an etched image (after a pattern transfer step such as etching), or in other ways.

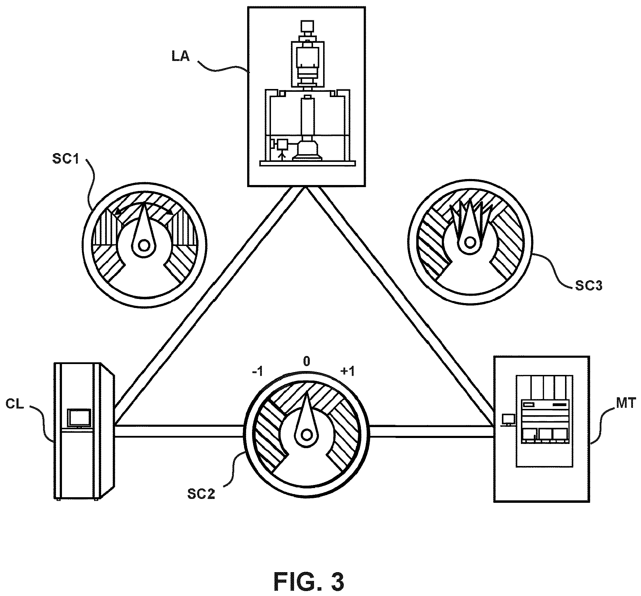

Figure 3 depicts a schematic representation of holistic lithography, representing a cooperation between three technologies to optimize semiconductor manufacturing. Typically, the patterning process in a lithographic apparatus LA is one of the most critical steps in the processing which requires high accuracy of dimensioning and placement of structures on the substrate W (Figure 1). To ensure this high accuracy, three systems (in this example) may be combined in a so called "holistic" control environment as schematically depicted in Figure. 3. One of these systems is the lithographic apparatus LA which is (virtually) connected to a metrology apparatus (e.g., a metrology tool) MT (a second system), and to a computer system CL (a third system). A "holistic" environment may be configured to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) a design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Figure 3 by the arrow pointing "0" in the second scale SC2).

The metrology apparatus (tool) MT may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

In lithographic processes, it is desirable to make frequent measurements of the structures created, e.g.,

for process control and verification. Tools to make such measurements include metrology tool (apparatus) MT. Different types of metrology tools MT for making such measurements are known, including scanning electron microscopes (SEM) or various forms of scatterometer metrology tools MT. In some embodiments, metrology tools MT are or include an SEM.

In some embodiments, metrology tools MT are or include a spectroscopic scatterometer, an ellipsometric scatterometer, or other light based tools. A spectroscopic scatterometer may be configured such that the radiation emitted by a radiation source is directed onto target features of a substrate and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra. An ellipsometric scatterometer allows for determining parameters of a lithographic process by measuring scattered radiation for each polarization states. Such a metrology tool (MT) emits polarized light (such as linear, circular, or elliptic) by using, for example, appropriate polarization filters in the illumination section of the metrology apparatus. A source suitable for the metrology apparatus may provide polarized radiation as well.

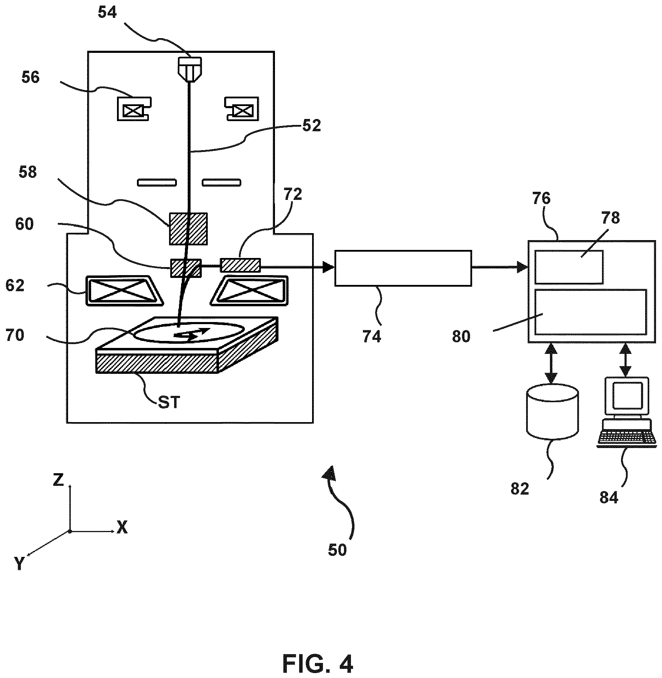

As described above, fabricated devices (e.g., patterned substrates) may be inspected at various points during manufacturing. Figure 4 schematically depicts a generalized embodiment of an charged particle (electron beam) inspection apparatus 50. In some embodiments, inspection apparatus 50 may be an electron beam or other charged particle inspection apparatus (e.g., the same as or similar to a scanning electron microscope (SEM)) that yields an image of a structure (e.g., some or all the structure of a device, such as an integrated circuit) exposed or transferred on a substrate. A primary electron beam 52 emitted from an electron source 54 is converged by condenser lens 56 and then passes through a beam deflector 58, an E x B deflector 60, and an objective lens 62 to irradiate a substrate 70 on a substrate table ST at a focus.

When the substrate 70 is irradiated with electron beam 52, secondary electrons are generated from the substrate 70. The secondary electrons are deflected by the E x B deflector 60 and detected by a secondary electron detector 72. A two-dimensional electron beam image can be obtained by detecting the electrons generated from the sample in synchronization with, e.g., two dimensional scanning of the electron beam by beam deflector 58 or with repetitive scanning of electron beam 52 by beam deflector 58 in an X or Y direction, together with continuous movement of the substrate 70 by the substrate table ST in the other of the X or Y direction. Thus, in some embodiments, the electron beam inspection apparatus has a field of view for the electron beam defined by the angular range into which the electron beam can be provided by the electron beam inspection apparatus (e.g., the angular range through which the deflector 60 can provide the electron beam 52). Thus, the spatial extent of the field of the view is the spatial extent to which the angular range of the electron beam can impinge on a surface (wherein the surface can be stationary or can move with respect to the field).

As shown in Figure 4, a signal detected by secondary electron detector 72 may be converted to a digital signal by an analog/digital (A/D) converter 74, and the digital signal may be sent to an image processing system 76. In some embodiments, the image processing system 76 may have memory 78 to store all or part of digital images for processing by a processing unit 80. The processing unit 80 (e.g., specially designed hardware or a combination of hardware and software or a computer readable medium comprising software) is configured to convert or process the digital images into datasets representative of the digital images. In some embodiments, the processing unit 80 is configured or programmed to cause execution of an operation (e.g., SEM inspection) described herein. Further, image processing system 76 may have a storage medium 82 configured to store the digital images and corresponding datasets in a reference database. A display device 84 may be connected with the image processing system 76, so that an operator can conduct necessary operation of the equipment with the help of a graphical user interface.

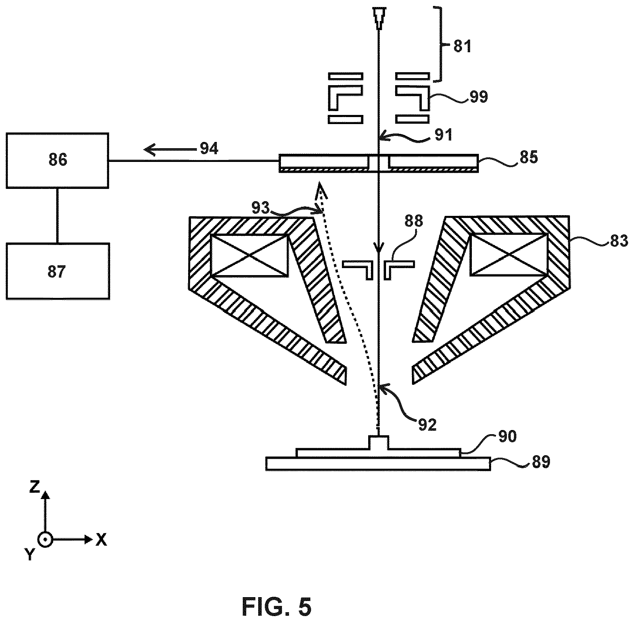

Figure 5 schematically illustrates another embodiment of a charged particle inspection apparatus. The apparatus is used to inspect a sample 90 (such as a patterned substrate) on a sample stage 89 and comprises a charged particle beam generator 81, a condenser lens module 99, a probe forming objective lens module 83, a charged particle beam deflection module 88, a secondary charged particle detector module 85, an image forming module 86, or other components. The charged particle beam generator 81 generates a primary charged particle beam 91. The condenser lens module 99 condenses the generated primary charged particle beam 91. The probe forming objective lens module 83 focuses the condensed primary charged particle beam into a charged particle beam probe 92. The charged particle beam deflection module 88 scans the formed charged particle beam probe 92 across the surface of an area of interest on the sample 90 secured on the sample stage 89. In some embodiments, the charged particle beam generator 81, the condenser lens module 83, and the probe forming objective lens module 83, or their equivalent designs, alternatives or any combination thereof, together form a charged particle beam probe generator which generates the scanning charged particle beam probe 92.

The secondary charged particle detector module 85 detects secondary charged particles 93 emitted from the sample surface (maybe also along with other reflected or scattered charged particles from the sample surface) upon being bombarded by the charged particle beam probe 92 to generate a secondary charged particle detection signal 94. The image forming module 86 (e.g., a computing device) is coupled with the secondary charged particle detector module 85 to receive the secondary charged particle detection signal 94 from the secondary charged particle detector module 85 and accordingly form at least one scanned image. In some embodiments, the secondary charged particle detector module 85 and image forming module 86, or their equivalent designs, alternatives or any combination thereof, together form an image forming apparatus which forms a scanned image from detected secondary charged particles emitted from sample 90 being bombarded by the charged particle beam probe 92.

In some embodiments, a monitoring module 87 is coupled to the image forming module 86 of the image forming apparatus to monitor, control, etc. the patterning process or derive a parameter for patterning process design, control, monitoring, etc. using the scanned image of the sample 90 received from image forming module 86. In some embodiments, the monitoring module 87 is configured or programmed to cause execution of an operation described herein. In some embodiments, the monitoring module 87 comprises a computing device. In some embodiments, the monitoring module 87 comprises a computer program configured to provide functionality described herein. In some embodiments, a probe spot size of the electron beam in the system of Figure 5 is significantly larger compared to, e.g., a CD, such that the probe spot is large enough so that the inspection speed can be fast. However, the resolution may be lower because of the large probe spot.

As described above, it may be desirable to use one or more tools to produce results that, for example, can be used to design, control, monitor, etc., a patterning process. One or more tools used in computationally controlling, designing, etc. one or more aspects of the patterning process, such as the pattern design for a patterning device (including, for example, adding sub-resolution assist features or optical proximity corrections), the illumination for the patterning device, etc., may be provided. Accordingly, in a system for computationally controlling, designing, etc. a manufacturing process involving patterning, the manufacturing system components or processes can be described by various functional modules or models. In some embodiments, one or more electronic (e.g., mathematical, parameterized, etc.) models may be provided that describe one or more steps or apparatuses of the patterning process. In some embodiments, a simulation of the patterning process can be performed using one or more electronic models to simulate how the patterning process forms a patterned substrate using a design pattern provided by a patterning device.

Images, from, e.g., the system of Figure 4 or Figure 5, may be processed to extract dimensions, shapes, contours, or other information that describe the edges of objects, representing semiconductor device structures, in the image. The shapes, contours, or other information may be quantified via metrics, such as edge placement error (EPE), CD, etc. at user-defined cut-lines or in other locations. These shapes, contours, or other information may be used to optimize a patterning process, for example.

In some embodiments, optimization of a patterning process may be represented as a cost function. The optimization process may comprise finding a set of parameters (design variables, process variables, etc.) of the patterning process that minimizes the cost function. The cost function can have any suitable form depending on the goal of the optimization. For example, the cost function can be weighted root mean square (RMS) of deviations of certain characteristics (evaluation points) of the system with respect to the intended values (e.g., ideal values) of these characteristics. The cost function can also be the maximum of these deviations (i.e., worst deviation). The term "evaluation points" should be interpreted broadly to include any characteristics of the system or fabrication method. The design or process variables of the patterning process can be confined to finite ranges or be interdependent due to practicalities of implementations of the system or method. In the case of a lithographic projection apparatus, the constraints are often associated with physical properties and characteristics of the hardware such as tunable ranges, or patterning device manufacturability design rules. The evaluation points can include physical points in an image of a substrate, as well as non-physical characteristics such as one or more etching parameters, dose and focus, etc., for example.

In an etching system, as an example, a cost function (CF) may be expressed as

$$CF(z_1, z_2, \cdots, z_N) = \sum_{p=1}^{P} w_p f_p^2(z_1, z_2, \cdots, z_N)$$

where ($z_1$, $z_2$, $\cdots$, $z_N$) are N design variables or values thereof, and $f_p(z_1, z_2, \cdots, z_N)$ can be a function of the design variables ($z_1$, $z_2$, $\cdots$, $z_N$) such as a difference between an actual value and an intended value of a characteristic for a set of values of the design variables of ($z_1, z_2, \cdots, z_N$). In some embodiments, $w_p$ is a weight constant associated with $f_p(z_1, z_2, \cdots, z_N)$. For example, the characteristic may be a position of an edge of a pattern (e.g., or multiple points on an edge that form a contour), measured at a given point on the edge. Different $f_p(z_1, z_2, \cdots, z_N)$ may have different weight $w_p$. For example, if a particular edge has a narrow range of permitted positions, the weight $w_p$ for the $f_p(z_1, z_2, \cdots, z_N)$ representing the difference between the actual position and the intended position of the edge may be given a higher value. $f_p(z_1, z_2, \cdots, z_N)$ can also be a function of an interlayer characteristic, which is in turn a function of the design variables ($z_1$, $z_2$, $\cdots$, $z_N$). Of course, $CF(z_1, z_2, \cdots, z_N)$ is

not limited to the form in the equation above and $CF(z_1, z_2, \cdots, z_N)$ can be in any other suitable form.

The cost function may represent any one or more suitable characteristics of a patterning system, a patterning process, lithographic apparatus, lithography process, or the substrate, for instance, focus, CD, image shift, image distortion, image rotation, stochastic variation, throughput, local CD variation, process window, an interlayer characteristic, or a combination thereof. In some embodiments, the cost function may include a function that represents one or more characteristics of a resist image. For example, $f_p(z_1, z_2, \cdots, z_N)$ can be simply a distance between a point in the resist image to an intended position of that point (i.e., edge placement error $EPE_p(z_1, z_2, \cdots, z_N)$ after etching, for example, or some other process. The parameters (e.g., design variables) can include any adjustable parameter such as an adjustable parameter of the etching system, the source, the patterning device, the projection optics, dose, focus, etc.

The parameters (e.g., design variables) may have constraints, which can be expressed as $(z_1, z_2, \cdots, z_N) \in Z$, where Z is a set of possible values of the design variables. One possible constraint on the design variables may be imposed by a desired throughput of the lithographic projection apparatus. Without such a constraint imposed by the desired throughput, the optimization may yield a set of values of the design variables that are unrealistic. Constraints should not be interpreted as a necessity.

Optimization of a patterning process may be based on inspection data obtained from a non-production, or mask check wafer. During the manufacturing of integrated circuits, a regular production wafer will undergo many hundreds or thousands of process steps, out of which there are often many tens of lithographic exposures. A mask check wafer may be a so called short loop wafer that will often undergo only a few deposition steps and sometimes only one lithography step, followed by development and possibly a (few) etch steps. Thus, a mask check wafer is a wafer that only undergoes a very small subset of the typical processing steps of a production wafer, to verify the lithography step, or defects introduced by errors on the mask. A mask check wafer is not subject to pressures from a production schedule, throughput requirements, yield or quality requirements, or other requirements of a regular production patterning process. As described above, since a mask check (non-production) wafer can utilize a different patterning process than a production wafer (which uses a regular production patterning process), different patterning parameters that lead to a reduction of the productivity of the patterning system can be utilized, and an improved ratio of patterning device defect (e.g., a particle on the mask) patternability (printability) to stochastic defects can be achieved. Stochastic defects are defects caused by parameters of the patterning process (e.g., the high-contrast illumination or other parameters). Because of this, the number of sites, and therefore the throughput, of a charged particle inspection and analysis can be significantly improved.

With the present systems and methods, an area scan is conducted where one (or a few) entire fields are inspected to find possible defects. In this step, both mask defects as well as process defects (such as stochastic defects) may be found. A repeater analysis (or review step) is also performed. During this step the defects found in the area scan are inspected in multiple fields to see which ones repeat (and are therefore mask defects), and which do not repeat (and are therefore process defects). Advantageously, the number of sites to be inspected in the repeater analysis is reduced. The area scan can be performed both with a charged particle inspection system (typically multibeam) or with optical methods such as bright field inspection, while the repeater analysis is performed with the charged particle inspection system. In some embodiments, modulation of process parameters is applied for the area scan to enhance the printability of the defects. For the repeater analysis, a small or no modulation is used such that the fields inspected during the repeater analysis are closer to production settings. This is described in further detail below.

A distinction between stochastic defects and patterning device printing defects (e.g., caused by mask particles) can be made by performing repeating inspections of a patterned substrate (e.g., as described above). Patterning device defects will repeat in multiple fields during inspection with a charged particle inspection system, while stochastic defects will generally not repeat in multiple fields. A field comprises a part of a substrate (e.g., wafer) that includes a single image of the patterning device (e.g., mask). The size of a field is limited by the size of the patterning device, and is typically limited to 26mm x 33mm. Many fields fit on a 300mm substrate, for example.

Practically, there is a limitation on how many sites can be inspected during the repeating analysis. Typically, for example, 100 to 1000 sites can be inspected in multiple (e.g., 10 to 50) fields with a single beam charged particle inspection tool such as an SEM. Stochastics (e.g., localized, often random variability from one patterned feature to the next in a patterned substrate that should print identically) may impact the printability of a defect (e.g., a particle) in a patterning device (e.g., a mask). A particle, for example, may print in one field, but not in another. This poses challenges since an charged particle inspection only typically covers one field. Hence, enhancing a probability of picking up a defect in an inspected field is important. A potential problem with existing technology is that modulation required to increase the printing probability of a patterning device defect (e.g., a particle) enough to ensure reliable detection leads to many more stochastic defects than the 100 to 1000 sites in one field that can be inspected in the repeating analysis.

Advantageously, the present disclosure describes techniques for increasing the ratio of patterning device defects patterned into a substrate relative to stochastic defects in the patterned substrate. The probability of on substrate defects caused by stochastics is reduced, and the probability of on substrate patterning device defects in increased, by modulating patterning process parameters. This may include, for example, using high-contrast/low-pupil fill ratio (PFR) illumination. Using illumination with a pupil-fill ratio parameter below 20% allows use of a part of a pupil that provides the highest imaging contrast. With current EUV illuminators, this results in illuminator efficiencies (e.g., < 100%), and hence a throughput penalty. For patterning regular production substrates, this is undesirable.

However, this tradeoff is different for a non-production or mask check substrate. Throughput is less critical and the elevated contrast can be used to reduce the number of stochastic defects on a patterned substrate, which improves the ratio of patterning device defect patternability to stochastic defects. This facilitates detection of patterning device defects more easily because parameter modulation enhances the patternability of patterning device defects, without generating too many stochastic defects.

Modulating patterning process parameters may also, or instead, include exposing a substrate coated with a higher dose resist compared to a regular production patterning process resist. This allows a substrate to be exposed longer (than in the regular production pattering process), such that the impact of photon shot noise, for example, is reduced. Photon shot noise leads to noise in an EUV exposure dose received by the substrate, for example, which results in a variability in the feature size and stochastic defects on the wafer. In addition, the origin on photon shout noise may comprise Poisson noise. Because the number of photons per feature is limited, there may be statistical variation in the number of photons.

Modulating patterning process parameters also allows easier detection of patterning device defects because parameter modulation (e.g., the higher dose resist, the actual dose, or the focus in this example) may be used to enhance the patternability of the patterning device defects, again without generating too many stochastic defects. Modulation of other patterning process parameters is also contemplated.

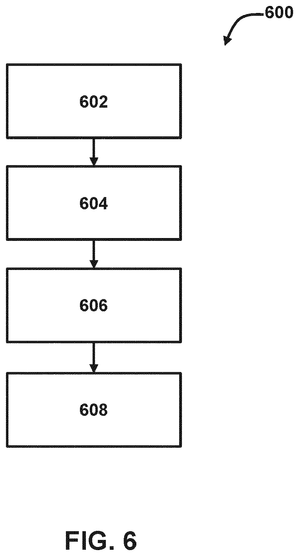

Figure 6 illustrates an exemplary method 600 for detecting a defect in a patterning device. The defect in the patterning device may be or include a particle, a tin (Sn) droplet, or other defects that may build up during the lifetime of a patterning device, repair related defects or imperfections, or other defects. Method 600 comprises inspecting (operation 602) a patterned substrate (e.g., a wafer) with a charged particle inspection system (e.g., an SEM), detecting (operation 604) a defect in the patterned substrate associated with an enhanced patternability of the defect in the patterning device, detecting (operation 606) the defect in the patterning device based on the defect in the patterned substrate, repeating (operation 608) the inspection at candidate defect areas on the patterned substrate in multiple fields to determine which defects repeat across the patterned substrate and thus were enhanced by modulating the patterning parameters, or other operations. By way of one possible example, the defect may be a particle, the patterning device may be a mask, the patterned substrate may be a patterned wafer, and the charged particle inspection system may be an SEM. In some embodiments, different SEM tools can be used for the area (e.g., first) scan and for the repeater analysis. Typically, the area scan is done using a multibeam SEM. The repeater analysis can also be performed using a multibeam tool, but typically it is advantageous to use a single beam SEM for the repeater analysis.

In some embodiments, a non-transitory computer readable medium stores instructions which, when executed by a computer, cause the computer to execute one or more of operations 602-608, or other operations. The operations of method 600 are intended to be illustrative. In some embodiments, method 600 may be accomplished with one or more additional operations not described, or without one or more of the operations discussed. Additionally, the order in which the operations of method 600 are illustrated in Figure 6 and described herein is not intended to be limiting.

At operation 602, a patterned substrate is inspected with the charged particle inspection system. The charged particle inspection may be an area scan where (at least) one full field (described above) is inspected. The charged particle inspection system can be or include a scanning electron microscope (e.g., as shown in Figures 4 and 5 and described above), for example, or other charged particle inspection systems such as a multibeam charged particle inspection system. The charged particle inspection system is configured to generate images that include information describing the geometrical shapes of contours in a pattern or information related to the geometrical shapes. The geometrical shapes of the contours in the pattern may be two dimensional geometrical shapes, for example. The images include data that describes the characteristics of the contours (e.g., such as X-Y dimensional data points, a mathematical equation that describes a geometrical shape, etc.), processing parameters associated with the contour, or other data. The images may further include 3D information, such as information about features that are buried in one or more sub-layers, data from prior inspections of prior layers, information selected and input by a user operating inspection system that generates the inspection images, or other information.

The patterned substrate is produced using the patterning device and by modulating patterning parameters compared to patterning parameters used during a regular production patterning process. In some embodiments, the regular patterning process is a semiconductor manufacturing process. A regular production patterning process may include any patterning process used in the normal course of producing a volume of patterned substrates. A regular production patterning process may have several process steps, which each have parameters that define a process window used to produce a patterned substrate (which may include functional integrated circuits, for example). Modulating the patterning process parameters compared to patterning parameters used during a regular production patterning process can include increasing or decreasing a level or a set point of a patterning parameter, adding or removing an amount of a process component, adding or removing a patterning process step, or otherwise adjusting a patterning process parameter from what it would have been for the regular production patterning process. This may include adjustments inside or outside the process window for a parameter.

Modulating the patterning parameters enhances the patternability of the defect onto the patterned substrate relative to a patternability of the defect in the regular production patterning process. In some embodiments, enhancing the patternability of the patterning device defect onto the patterned substrate comprises improving the ratio of patterning device defects (e.g., particles on a mask) to stochastic defects patterned on a substrate. Modulating the patterning parameters to enhance the patternability of the defect in the patterning device onto the patterned substrate comprises modulating the patterning parameters to enhance a likelihood that the defect in the patterning device is patterned onto the patterned substrate relative to a likelihood of patterning the defect in the regular production patterning process.

Modulating the patterning parameters also balances the enhanced patternability with a quantity of patterned defects in the patterned substrate associated with the modulated patterning parameters (e.g., stochastic defects). Balancing the enhanced patternability with a quantity of patterned defects in the patterned substrate associated with the modulated patterning parameters refers to ensuring a defect in a patterning device will be patterned (e.g., printed) with a high enough probability to make a corresponding defect regularly appear on the patterned substrate, while limiting a number of stochastic defects (e.g., defects caused by the patterning parameters themselves, and not the defect in the patterning device).

As described below, this keeps a number of sites that need to be inspected during a repeat analysis (operation 608) limited to an acceptable level. An acceptable level may be determined based on time (e.g., such that the repeat analysis only requires some threshold amount of time to perform), determined based on a number of inspection sites (e.g., such that the repeat analysis only requires inspection of a target number of sites on the patterned wafer), or may be determined in other ways.

Modulating the patterning parameters is performed without regard for the patterning productivity of the patterned substrate (e.g., a mask check wafer). This is because, as described above, the modulation is performed for a non-production substrate. A non-production substrate may include a check wafer, or other substrates, for example.

In some embodiments, the patterned substrate is produced with a lithography system, which may be or include LA described above (see Figure 2, for example), a scanner, or other components, associated with the regular production patterning process, or a separate lithography system. In some embodiments, the patterned substrate is produced using the patterning device and by modulating patterning parameters compared to patterning parameters used during the regular production patterning process is for a pattern design that is the same as a pattern design used in the regular production patterning process. In other words, even though a mask check wafer may be used in method 600, a regular production design may be patterned onto the substrate.

In some embodiments, modulating the patterning parameters comprises coating the substrate with a different, higher dose resist compared to a regular production patterning process resist. In some embodiments, modulating the patterning parameters comprises varying a dose or focus of exposure illumination associated with the regular production patterning process. In some embodiments, modulating the patterning parameters comprises coating the substrate with a different resist compared to a regular production patterning process resist and varying the dose of the exposure illumination associated with the regular production patterning process. Varying the dose may comprise decreasing or increasing the dose relative to a dose used for the regular production patterning process.

For example, dose modulation may be used to enhance a printability of a defect. This dose modulation may comprise lowering the dose, resulting in an under exposure which increases the likelihood of a defect. However, modulation may also or instead comprise exposing a different, higher dose resist. This higher dose resist requires a higher exposure dose for a nominal exposure. In addition, in order to increase the likelihood of a defect, this higher dose resist may be underexposed. Note that it could be that the net dose is still an increase dose with respect to the regular production patterning process, which is not under exposed, but uses a more sensitive resist.

In some embodiments, modulating the patterning parameters comprises providing higher contrast illumination for patterning compared to illumination provided during the regular production patterning process. This may include modulating the patterning parameters by varying a pupil fill ratio (PFR) associated with the regular patterning process. A pupil may be a component of a lithography system (e.g., LA described above) configured to provide a desired angular distribution of illumination onto the patterning device, for example. A PFR is the percentage of the illumination pupil that is filled with light. With current EUV illumination systems, PFRs below 20% cannot be made without loss of illumination efficien-

cy (IE), which leads to throughput loss. In some embodiments, for example, the PFR is varied to less than 20%, which causes an illuminator efficiency of the regular patterning process to be less than 100%. This technique can be used to obtain an illumination setting with elevated contrast, for example.

At an operation 604, a defect in the patterned substrate is detected. The defect is associated with an enhanced patternability of the defect in the patterning device. A defect associated with the enhanced patternability may be caused by the modulated patterning parameters, enlarged or decreased by the modulated patterning parameters, made more or less frequent by the modulated patterning parameters, or have another association with the enhanced patternability of the defect in the patterning device. In contrast, a defect produced with a regular production patterning process may print less often, be less pronounced, or not print at all. In some embodiments a defect may comprise a particle, a tin (Sn) droplet, or other defects that may build up during the lifetime of a patterning device, repair related defects or imperfections, or other defects.

At operation 606, the defect in the patterning device is detected based on the defect in the patterned substrate. Detecting the defect in the patterning device based on the defect in the patterned substrate may comprise mapping the defect in the patterned substrate back to the patterning device, analyzing and comparing dimensions of features of the patterned substrate and the patterning device, or other analysis. For example, a defect in the patterning device may appear at a specific location on the patterned substrate. Because the pattern on the patterning device is repeatedly reproduced across the substrate, the location of a defect on the patterning device may be determined based on the defects in the patterned substrate. Alignment information between the patterning device and the substrate, geometrical dimensions of the pattern, or other information may be used to determine the location of the defect in the patterning device based on the defects detected on the patterned substrate.

At operation 608, the inspection is repeated at candidate defect areas on the patterned substrate. The inspection is repeated in multiple fields. The inspection is repeated to determine which defects repeat across the patterned substrate and thus were enhanced by modulating the patterning parameters. Candidate defect areas include areas on the patterned substrate identified during the area scan (operation 602) as potentially including defects caused by modulating the patterning process parameters. In other words, method 600 includes two (or more) inspection steps. The two steps include operation 602 described above, and operation 608, which comprises a repeat inspection and analysis where hotspots on the patterned substrate (e.g., areas of the patterned substrate which include candidate defects) were found in operation 602 (e.g., the area scan). These hotspots are inspected in multiple fields to determine which defects repeat (and are therefore caused by the defect in the patterning device).

As described above, the enhanced patternability (e.g., printability) of the defect in the patterning device (e.g., mask) is balanced with a quantity of patterned defects in the patterned substrate associated with the modulated patterning parameters. This ensures a defect in a patterning device will be patterned (e.g., printed) with a high enough probability to make a corresponding defect regularly appear on the patterned substrate, while limiting a number of stochastic defects (e.g., defects caused by the patterning parameters themselves, and not the defect in the patterning device). This keeps a number of sites that need to be inspected during a repeat analysis (operation 608) limited to an acceptable level. An acceptable level may be determined based on time (e.g., such that the repeat analysis only requires some threshold amount of time to perform), determined based on a number of inspection sites (e.g., such that the repeat analysis only requires inspection of a target number of sites on the patterned wafer), or may be determined in other ways. By way of a non-limiting example, an acceptable level may be about 100 - 1000 sites that include candidate defects.

Returning to the example patterning process parameter modulation examples above (higher dose resist or high contrast / low pupil fill ratio illumination), in some embodiments, a field that is used for the area scan (operation 602) can be exposed using the high-contrast/low-PFR illumination, while fields that are used for the repeating inspections (operation 608) can be exposed under nominal conditions such that a decision regarding the presence of a particle defect is made under conditions representative of high volume manufacturing. In some embodiments, if one single substrate is used for the area scan (operation 602) and the repeating inspections (operation 608), the repeating inspections may also be performed on fields exposed at a higher dose. If needed, the repeating inspections may be performed on fields exposed under nominal conditions such that a decision regarding the presence of a patterning device defect is again made under conditions representative of high volume manufacturing, using a second non-production or check substrate (wafer) which is coated with a nominal (e.g., a regular production patterning process) resist.

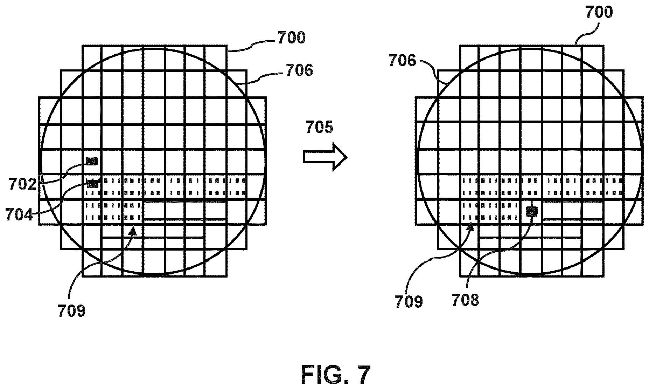

Figure 7 illustrates a generalized example of patterning device 700 defects 702, 704 that are not patterned 705 onto substrate 706, while a stochastic defect 708 is patterned. As described herein, the present systems and methods are configured such that the defect patternability or printability (e.g., of defects 702, 704) can be enhanced without leading to an excessive amount of stochastic defects (e.g., defect 708). Because of this, the number of sites, and therefore the throughput, required for a charged particle inspection and analysis can be significantly improved (e.g., a decreased number of sites and increased throughput). Figure 7 also illustrates exposing a number of fields 709 with different modulation magnitudes to select the modulation magnitude that gives an acceptable amount of stochastic defects. The repeater analysis is done on the non-modulated fields.

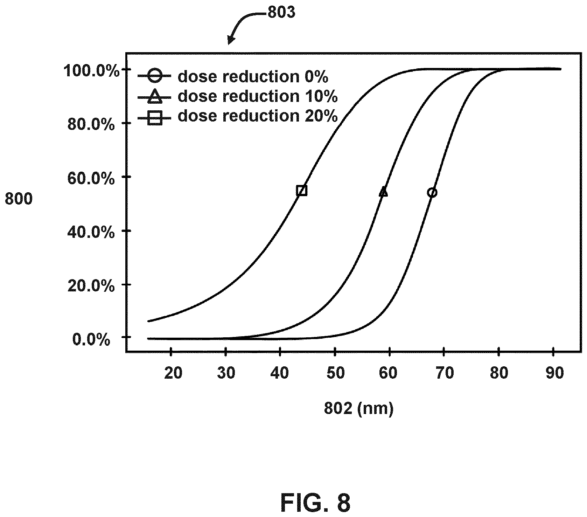

Figure 8 generally illustrates defect printability 800 versus particle size 802. Figure 8 also illustrates how defect printability 800 increases with a decreasing dose (e.g., dose reduction 803 - by 10% and 20% from a 0% starting point). As described herein, dose modulation may be used to enhance a printability of a defect. This dose modulation may comprises lowering the dose, resulting in an under exposure which increases the likelihood of a defect (e.g., as shown in Figure 8). However, modulation may also or instead comprise exposing a different, higher dose resist. This higher dose resist requires a higher exposure dose for a nominal exposure. In addition, in order to increase the likelihood of a defect, this higher dose resist may be underexposed. Note that it could be that the net dose is still an increase dose with respect to the regular production patterning process, which is not under exposed, but uses a more sensitive resist. To provide even more clarity about the distinction between particle defects on a mask and stochastic defects - lowering the dose is good for detecting particle defects on a mask, but leads to more stochastic defects (undesired). Using a high dose resist results in fewer stochastic defects, so there is more room to use a lower-than-nominal dose and increase the particle-defect printability.

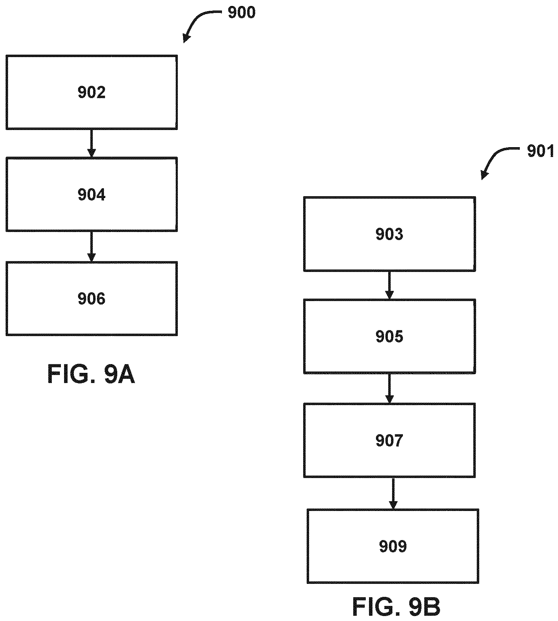

Figures 9A and 9B illustrate exemplary methods 900 and 901 for enhancing patterning of a defect in a patterning device onto a substrate. Method 900 comprises modulating (operation 902) patterning parameters of a regular production patterning process, patterning (operation 904) the defect in the patterning device onto the substrate using modulated patterning parameters, inspecting (operation 906) the substrate using a full field inspection and at candidate defect areas on the substrate in multiple fields to determine which defects repeat across the substrate and thus were enhanced by modulating the patterning parameters, or other operations.

In some embodiments, like method 600 shown in Figure 6, a non-transitory computer readable medium (e.g., the same or similar medium to that associated with the operations of Figure 6) stores instructions which, when executed by a computer, cause the computer to execute one or more of operations 902-906, 903-909 (Figure 9B), or other operations. The operations of method 900 and 901 are intended to be illustrative. In some embodiments, method 900 or 901 may be accomplished with one or more additional operations not described, or without one or more of the operations discussed. Additionally, the order in which the operations of method 900 are illustrated in Figure 9A and method 901 are illustrated in Figure 9B, and described herein is not intended to be limiting. Note that many of the operations of method 900 or 901 correspond to the operations of method 600 described above, and the descriptions of the operations of method 600 apply to the corresponding operations of method 900 or 901 (and so are not repeated below).

Referring to Figure 9A, and as described above, at operation 902, patterning parameters of a regular patterning process are modulated. In some embodiments, the regular patterning process is a semiconductor patterning process. The patterning parameters may be automatically or otherwise electronically adjusted by a processor (e.g., a computer controller), modulated manually by a user, or modulated in other ways. Modulating the patterning parameters enhances a patternability of the defect in the patterning device onto the substrate compared to a patternability of the defect in the regular production patterning process.

In some embodiments, modulating the patterning parameters comprises coating the substrate with a different, higher dose resist compared to a regular production patterning process resist. In some embodiments, modulating the patterning parameters comprises varying a dose or focus of exposure illumination associated with the regular production patterning process. In some embodiments, modulating the patterning parameters comprises coating the substrate with a different resist compared to a regular production patterning process resist and varying the dose of the exposure illumination associated with the regular production patterning process. In some embodiments, varying the dose comprises increasing or decreasing the dose relative to a dose used for the regular production patterning process.

In some embodiments, modulating the patterning parameters comprises providing higher contrast illumination for patterning compared to illumination provided during the regular production patterning process. This may comprise modulating the patterning parameters comprises varying a pupil fill ratio (PFR) associated with the regular patterning process. In some embodiments, the PFR is varied to less than 20%, which causes an illuminator efficiency of the regular patterning process to be less than 100%.

At operation 904, a defect in a patterning device is patterned onto a substrate using modulated parameters. In some embodiments, the patterning device is a mask. The patterning may be permed by a patterning system such as the lithographic projection apparatus shown in Figure 1 and described above, LA shown in Figure 2, or other patterning systems. After patterning with the modulated patterning parameters, and because of the enhanced patternability of the defect balanced with the quantity of patterned defects associated with the modulated patterning parameters, the substrate is configured for inspection with a charged particle inspection system. In some embodiments, the charged particle inspection system is a scanning electron microscope (SEM). As with method 600 (Figure 6), modulating the patterning parameters enhances the patternability of the defect onto the patterned substrate relative to a patternability of the defect in the regular production patterning process, and balances the enhanced patternability with a quantity of patterned defects in the patterned substrate associated with the modulated patterning parameters. It is also performed without regard for the patterning productivity of the patterned substrate (e.g., a mask check wafer). In some embodiments, the patterned defects in the patterned substrate associated with the modulated patterning parameters comprise stochastic defects.

In some embodiments, the patterned substrate is produced with a lithography system (e.g., which may be or include the lithographic projection apparatus shown in Figure 1, LA shown in Figure 2, a scanner, or other components) associated with the regular production patterning process or a separate lithography system. The patterned substrate may be a patterned semiconductor wafer and the defect in the patterning device may comprise a particle on the patterning device, for example. In some embodiments, the patterned substrate produced using the patterning device and by modulating patterning parameters compared to patterning parameters used during a regular production patterning process is produced using a pattern design and patterning device that are the same as a pattern design and a patterning device used in the regular production patterning process.

At operation 906, the substrate is inspected at candidate defect areas in multiple fields. Operation 906 may facilitate determination of which defects repeat across the substrate, and thus were enhanced by modulating the patterning parameters. As described above, modulating the patterning parameters to enhance the patternability of the defect in the patterning device onto the patterned substrate comprises modulating the patterning parameters to enhance a likelihood that the defect in the patterning device is patterned onto the patterned substrate relative to a likelihood of patterning the defect in the regular production patterning process.

In some embodiments, method 900 (and method 600 shown in Figure 6) may comprise adjusting charged particle inspections of patterned substrates for regular production patterning processes based on information output from the inspections of the candidate defect areas. For example, the inspections of the candidate defect areas may indicate the presence of a patterning device defect at a certain location. If the same or a similar mask is used for the regular production patterning process, regular production patterning process charged particle inspections may be adjusted to focus on corresponding locations on production substrates. In addition or instead, the regular production patterning process may be adjust (e.g., process parameters may be varied within a process window, a process may be added or subtracted, etc.) so that any effects on a printed pattern from a patterning device defect are minimized.

As shown in Figure 9B, method 901 comprises modulating (operation 903) patterning parameters of a regular production patterning process for only some fields (or lowering modulation parameters for those fields), patterning (operation 905) the defect in the patterning device onto the substrate using modulated (or lower modulated) patterning parameters for some fields, inspecting (operation 907) the substrate using a full field inspection, and performing the repeater analysis (operation 909) on non-modulated or lower modulated fields.

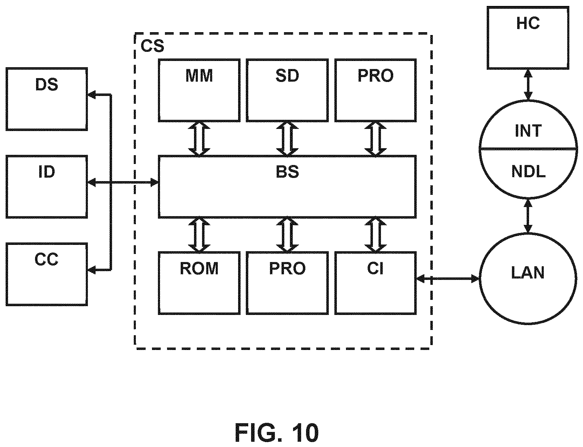

Figure 10 is a diagram of an example computer system CS (which may be similar to or the same as CL shown in Figure 3) that may be used for one or more of the operations described herein. Computer system CS includes a bus BS or other communication mechanism for communicating information, and a processor PRO (or multiple processors) coupled with bus BS for processing information. Computer system CS also includes a main memory MM, such as a random access memory (RAM) or other dynamic storage device, coupled to bus BS for storing information and instructions to be executed by processor PRO. Main memory MM also may be used for storing temporary variables or other intermediate information during execution of instructions by processor PRO. Computer system CS further includes a read only memory (ROM) ROM or other static storage device coupled to bus BS for storing static information and instructions for processor PRO. A storage device SD, such as a magnetic disk or optical disk, is provided and coupled to bus BS for storing information and instructions.

Computer system CS may be coupled via bus BS to a display DS, such as a cathode ray tube (CRT) or flat panel or touch panel display for displaying information to a computer user. An input device ID, including alphanumeric and other keys, is coupled to bus BS for communicating information and command selections to processor PRO. Another type of user input device is cursor control CC, such as a mouse, a trackball, or cursor direction keys for communicating direction information and command selections to processor PRO and for controlling cursor movement on display DS. This input device typically has two degrees of freedom in two axes, a first axis (e.g., x) and a second axis (e.g., y), that allows the device to specify positions in a plane. A touch panel (screen) display may also be used as an input device.

In some embodiments, portions of one or more methods described herein may be performed by computer system CS in response to processor PRO executing one or more sequences of one or more instructions contained in main memory MM. Such instructions may be read into main memory MM from another computer-readable medium, such as storage device SD. Execution of the sequences of instructions included in main memory MM causes processor PRO to perform the process steps (operations) described herein. One or more processors in a multi-processing arrangement may also be employed to execute the sequences of instructions contained in main memory MM. In some embodiments, hard-wired circuitry may be used in place of or in combination with software instructions. Thus, the description herein is not limited to any specific combination of hardware circuitry and software.

The term "computer-readable medium" as used herein refers to any medium that participates in providing instructions to processor PRO for execution. Such a medium may take many forms, including but not limited to, non-volatile media, volatile media, and transmission media. Non-volatile media include, for example, optical or magnetic disks, such as storage device SD. Volatile media include dynamic memory, such as main memory MM. Transmission media include coaxial cables, copper wire and fiber optics, including the wires that comprise bus BS. Transmission media can also take the form of acoustic or light waves, such as those generated during radio frequency (RF) and infrared (IR) data communications. Computer-readable media can be non-transitory, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge. Non-transitory computer readable media can have (machine-readable) instructions recorded thereon. The instructions, when executed by a computer, can implement any of the operations described herein. Transitory computer-readable media can include a carrier wave or other propagating electromagnetic signal, for example.

Various forms of computer readable media may be involved in carrying one or more sequences of one or more machine-readable instructions to processor PRO for execution. For example, the instructions may initially be borne on a magnetic disk of a remote computer. The remote computer can load the instructions into its dynamic memory and send the instructions over a telephone line using a modem. A modem local to computer system CS can receive the data on the telephone line and use an infrared transmitter to convert the data to an infrared signal. An infrared detector coupled to bus BS can receive the data carried in the infrared signal and place the data on bus BS. Bus BS carries the data to main memory MM, from which processor PRO retrieves and executes the instructions. The instructions received by main memory MM may optionally be stored on storage device SD either before or after execution by processor PRO.

By way of an example, for an SEM (e.g., as described above), a computer readable medium may be provided that stores instructions for a processor (PRO) of a controller (e.g., CS) to carry out image inspection, image acquisition, activating a charged-particle source, adjusting electrical excitation of stigmators, adjusting landing energy of electrons, adjusting objective lens excitation, adjusting secondary electron detector position and orientation, stage motion control, beam separator excitation, applying scan deflection voltages to beam deflectors, receiving and processing data associated with signal information from electron detectors, configuring an electrostatic element, detecting signal electrons, adjusting the control electrode potential, adjusting the voltages applied to the electron source, extractor electrode, and the sample, etc.

Computer system CS may also include a communication interface CI coupled to bus BS. Communication interface CI provides a two-way data communication coupling to a network link NDL that is connected to a local network LAN. For example, communication interface CI may be an integrated services digital network (ISDN) card or a modem to provide a data communication connection to a corresponding type of telephone line. As another example, communication interface CI may be a local area network (LAN) card to provide a data communication connection to a compatible LAN. Wireless links may also be implemented. In any such implementation, communication interface CI sends and receives electrical, electromagnetic, or optical signals that carry digital data streams representing various types of information.

Network link NDL typically provides data communication through one or more networks to other data devices. For example, network link NDL may provide a connection through local network LAN to a host computer HC. This can include data communication services provided through the worldwide packet data communication network, now commonly referred to as the "Internet" INT. Local network LAN (Internet) may use electrical, electromagnetic, or optical signals that carry digital data streams. The signals through the various networks and the signals on network data link NDL and through communication interface CI, which carry the digital data to and from computer system CS, are exemplary forms of carrier waves transporting the information.

Computer system CS can send messages and receive data, including program code, through the network(s), network data link NDL, and communication interface CI. In the Internet example, host computer HC might transmit a requested code for an application program through Internet INT, network data link NDL, local network LAN, and communication interface CI. One such downloaded application may provide all or part of a method described herein, for example. The received code may be executed by processor PRO as it is received, or stored in storage device SD, or other non-volatile storage for later execution. In this manner, computer system CS may obtain application code in the form of a carrier wave.

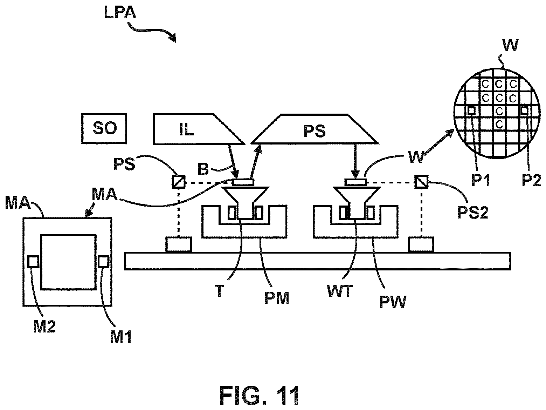

Figure 11 is a schematic diagram of another lithographic projection apparatus (LPA) that may be used for, or facilitate one or more of the operations described herein. The LPA shown in Figure 11 is similar to or the same as the apparatus shown in Figure 1. LPA can include source collector module SO, illumination system (illuminator) IL configured to condition a radiation beam B (e.g. EUV radiation), patterning device table T, substrate table WT, and projection system PS. Patterning device table T can be constructed to support a patterning device (e.g. a mask or a reticle) MA and connected to a first positioner PM configured to accurately position the patterning device. Substrate table (e.g. a wafer table) WT can be constructed to hold a substrate (e.g. a resist coated wafer) W and connected to a second positioner PW configured to accurately position the substrate. Projection system (e.g. a reflective projection system) PS can be configured to project a pattern imparted to the radiation beam B by patterning device MA onto a target portion C (e.g. comprising one or more dies) of the substrate W.

As shown in this example, LPA can be of a reflective type (e.g. employing a reflective patterning device). It is to be noted that because most materials are absorptive within the EUV wavelength range, the patterning device may have multilayer reflectors comprising, for example, a multi-stack of molybdenum and silicon. In one example, the multi-stack reflector has a 40 layer pairs of molybdenum and silicon where the thickness of each layer is a quarter wavelength. Even smaller wavelengths may be produced with X-ray lithography. Since most material is absorptive at EUV and x-ray wavelengths, a thin piece of patterned absorbing material on the patterning device topography (e.g., a TaN absorber on top of the multi-layer reflector) defines where features would print (positive resist) or not print (negative resist).

Illuminator IL can receive an extreme ultra violet radiation beam from source collector module SO. Methods to produce EUV radiation include, but are not necessarily limited to, converting a material into a plasma state that has at least one element, e.g., xenon, lithium, or tin, with one or more emission lines in the EUV range. In one such method, often termed laser produced plasma ("LPP"), the plasma can be produced by irradiating a fuel, such as a droplet, stream or cluster of material having the line-emitting element, with a laser beam. Source collector module SO may be part of an EUV radiation system including a laser (not shown in Figure 11), for providing the laser beam exciting the fuel. The resulting plasma emits output radiation, e.g., EUV radiation, which is collected using a radiation collector, disposed in the source collector module. The laser and the source collector module may be separate entities, for example when a $CO_2$ laser is used to provide the laser beam for fuel excitation. In this example, the laser may not be considered to form part of the lithographic apparatus and the radiation beam can be passed from the laser to the source collector module with the aid of a beam delivery system comprising, for example, suitable directing mirrors or a beam expander. In other examples, the source may be an integral part of the source collector module, for example when the source is a discharge produced plasma EUV generator, often termed a DPP source.

Illuminator IL may comprise an adjuster for adjusting the angular intensity distribution of the radiation beam. Generally, at least the outer or inner radial extent (commonly referred to as $\sigma$-outer and $\sigma$-inner, respectively) of the intensity distribution in a pupil plane of the illuminator can be adjusted. In addition, the illuminator IL may comprise various other components, such as faceted field and pupil mirror devices. The illuminator may be used to condition the radiation beam, to have a desired uniformity and intensity distribution in its cross section.

The radiation beam B can be incident on the patterning device (e.g., mask) MA, which is held by patterning device table T, and is patterned by the patterning device. After being reflected from the patterning device (e.g. mask) MA, the radiation beam B passes through the projection system PS, which focuses the beam onto a target portion C of the substrate W. With the aid of the second positioner PW and position sensor PS2 (e.g. an interferometric device, linear encoder, or capacitive sensor), the substrate table WT can be moved accurately (e.g. to position different target portions C in the path of radiation beam B). Similarly, the first positioner PM and another position sensor PS1 can be used to accurately position the patterning device (e.g. mask) MA with respect to the path of the radiation beam B. Patterning device (e.g. mask) MA and substrate W may be aligned using patterning device alignment marks M1, M2 and substrate alignment marks PI, P2.

The depicted apparatus LPA could be used in at least one of the following modes, step mode, scan mode, and stationary mode. In step mode, the patterning device table T and the substrate table WT are kept essentially stationary, while an entire pattern imparted to the radiation beam is projected onto a target portion C at one time (e.g., a single static exposure). The substrate table WT is then shifted in the X or Y direction so that a different target portion C can be exposed. In scan mode, the patterning device table T and the substrate table WT are scanned synchronously while a pattern imparted to the radiation beam is projected onto target portion C (i.e. a single dynamic exposure). The velocity and direction of substrate table WT relative to the patterning device table T may be determined by the (de)magnification and image reversal characteristics of the projection system PS. In stationary mode, the patterning device table T is kept essentially stationary holding a programmable patterning device, and substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

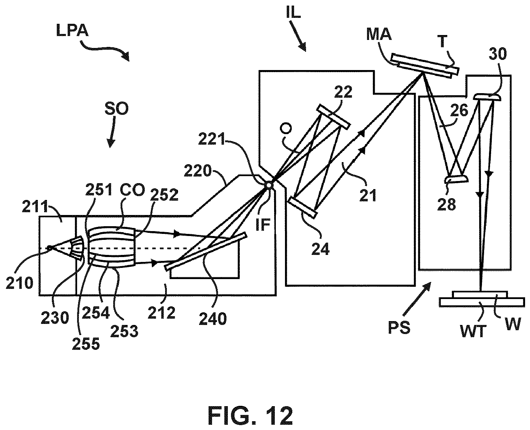

Figure 12 is a more detailed view of the lithographic projection apparatus shown in Figure 11 (or Figure 1). As shown in Figure 12, the LPA can include the source collector module SO, the illumination system IL, and the projection system PS. The source collector module SO is configured such that a vacuum environment can be maintained in an enclosing structure 220 of the source collector module SO. An EUV radiation emitting plasma 210 may be formed by a discharge produced plasma source. EUV radiation may be produced by a gas or vapor, for example Xe gas, Li vapor or Sn vapor in which the hot plasma 210 is created to emit radiation in the EUV range of the electromagnetic spectrum. The hot plasma 210 is created by, for example, an electrical discharge causing at least partially ionized plasma. Partial pressures of, for example, 10 Pa of Xe, Li, Sn vapor or any other suitable gas or vapor may be required for efficient generation of the radiation. In some embodiments, a plasma of excited tin (Sn) is provided to produce EUV radiation.

The radiation emitted by the hot plasma 210 is passed from a source chamber 211 into a collector chamber 212 via an optional gas barrier or contaminant trap 230 (in some cases also referred to as contaminant barrier or foil trap) which is positioned in or behind an opening in source chamber 211. The contaminant trap 230 may include a channel structure. Contamination trap 230 may also include a gas barrier or a combination of a gas barrier and a channel structure. The contaminant trap or contaminant barrier trap 230 (described below) also includes a channel structure. The collector chamber 211 may include a radiation collector CO which may be a grazing incidence collector. Radiation collector CO has an upstream radiation collector side 251 and a downstream radiation collector side 252. Radiation that traverses collector CO can be reflected off a grating spectral filter 240 to be focused on a virtual source point IF along the optical axis indicated by the line "O". The virtual source point IF is commonly referred to as the intermediate focus, and the source collector module is arranged such that the intermediate focus IF is located at or near an opening 221 in the enclosing structure 220. The virtual source point IF is an image of the radiation emitting plasma 210.

Subsequently, the radiation traverses the illumination system IL, which may include a facetted field mirror device 22 and a facetted pupil mirror device 24 arranged to provide a desired angular distribution of the radiation beam 21, at the patterning device MA, as well as a desired uniformity of radiation intensity at the patterning device MA. Upon reflection of the radiation beam 21 at the patterning device MA, held by the patterning device table T, a patterned beam 26 is formed and the patterned beam 26 is imaged by the projection system PS via reflective elements 28, 30 onto a substrate W held by the substrate table WT. More elements than shown may generally be present in illumination optics unit IL and projection system PS. The grating spectral filter 240 may optionally be present, depending upon the type of lithographic apparatus, for example. Further, there may be more mirrors present than those shown in the figures, for example there may be 1- 6 additional reflective elements present in the projection system PS than shown in Figure 12.

Collector optic CO, as illustrated in Figure 12, is depicted as a nested collector with grazing incidence reflectors 253, 254 and 255, just as an example of a collector (or collector mirror). The grazing incidence reflectors 253, 254 and 255 are disposed axially symmetric around the optical axis O and a collector optic CO of this type may be used in combination with a discharge produced plasma source, often called a DPP source.

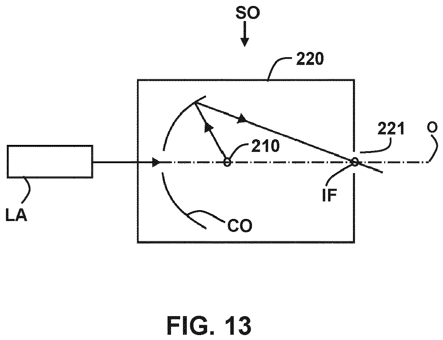

Figure 13 is a detailed view of source collector module SO of the lithographic projection apparatus LPA (shown in previous figures). Source collector module SO may be part of an LPA radiation system. A laser LA can be arranged to deposit laser energy into a fuel, such as xenon (Xe), tin (Sn) or lithium (Li), creating the highly ionized plasma 210 with electron temperatures of several 10"s of eV. The energetic radiation generated during de-excitation and recombination of these ions is emitted from the plasma, collected by a near normal incidence collector optic CO and focused onto the opening 221 in the enclosing structure 220.

Various embodiments are disclosed in the subsequent list of numbered clauses:

1. A method for detecting a defect in a patterning device, the method comprising: inspecting a patterned substrate with a charged particle inspection system, wherein the patterned substrate is produced using the patterning device and by modulating patterning parameters compared to patterning parameters used during a regular production patterning process, and wherein modulating the patterning parameters enhances a patternability of the defect onto the patterned substrate; detecting a defect in the patterned substrate associated with the enhanced patternability of the defect in the patterning device; and detecting the defect in the patterning device based on the defect in the patterned substrate.

2. The method of clause 1, wherein modulating the patterning parameters enhances the patternability of the defect onto the patterned substrate relative to a patternability of the defect in the regular production patterning process, and balances the enhanced patternability with a quantity of patterned defects in the patterned substrate associated with the modulated patterning parameters, and is performed without regard for the patterning productivity of the patterned substrate; wherein the method further comprises repeating the inspection at candidate defect areas on the patterned substrate in multiple fields to determine which defects repeat across the patterned substrate and thus were enhanced by modulating the patterning parameters. (1)

3. The method of any of the previous clauses, wherein modulating the patterning parameters comprises coating the substrate with a different, higher dose resist compared to a regular production patterning process resist. (1)

4. The method of any of the previous clauses, wherein modulating the patterning parameters comprises varying a dose or focus of exposure illumination associated with the regular production patterning process. (1)

5. The method of any of the previous clauses, wherein modulating the patterning parameters comprises coating the substrate with a different resist compared to a regular production patterning process resist and varying the dose of the exposure illumination associated with the regular production patterning process, and wherein varying the dose comprises increasing the dose relative to a dose used for the regular production patterning process. (4)

6. The method of any of the previous clauses, wherein modulating the patterning parameters comprises providing higher contrast illumination for patterning compared to illumination provided during the regular production patterning process. (1)

7. The method of any of the previous clauses, wherein modulating the patterning parameters comprises varying a pupil fill ratio (PFR) associated with the regular patterning process. (1)

8. The method of any of the previous clauses, wherein the PFR is varied to less than 20%, which causes an illuminator efficiency of the regular patterning process to be less than 100%. (7)

9. The method of any of any of the previous clauses, wherein the patterning device is a mask, and the regular patterning process is a semiconductor manufacturing process. (1)

10. The method of any of the previous clauses, wherein the charged particle inspection system is a scanning electron microscope (SEM). (1)

11. The method of any of the previous clauses, wherein modulating the patterning parameters to enhance the patternability of the defect in the patterning device onto the patterned substrate comprises modulating the patterning parameters to enhance a likelihood that the defect in the patterning device is patterned onto the patterned substrate relative to a likelihood of patterning the defect in the regular production patterning process. (1)

12. The method of any of the previous clauses, wherein the patterned defects in the patterned substrate associated with the modulated patterning parameters comprise stochastic defects. (1)

13. The method of any of the previous clauses, wherein the patterned substrate is produced with a lithography system associated with the regular production patterning process or a separate lithography system. (1)

14. The method of any of the previous clauses, wherein the patterned substrate is a patterned semiconductor wafer and the defect in the patterning device comprises a particle on the patterning device. (1)

15. The method of any of the previous clauses, wherein the patterned substrate produced using the patterning device and by modulating patterning parameters compared to patterning parameters used during a regular production patterning process is produced using a pattern design and patterning device that are the same as a pattern design and a patterning device used in the regular production patterning process. (1)

16. A system for detecting a defect in a patterning device, the system comprising: a charged particle inspection system configured for inspecting a patterned substrate, wherein the patterned substrate is produced using the patterning device and by modulating patterning parameters compared to patterning parameters used during a regular production patterning process, and wherein modulating the patterning parameters enhances a patternability of the defect onto the patterned substrate; and one or more processors configured by machine readable instructions to: detect a defect in the patterned substrate associated with the enhanced patternability of the defect in the patterning device; and detect the defect in the patterning device based on the defect in the patterned substrate.

17. The system of clause 16, wherein modulating the patterning parameters enhances the patternability of the defect onto the patterned substrate relative to a patternability of the defect in the regular production patterning process, and balances the enhanced patternability with a quantity of patterned defects in the patterned substrate associated with the modulated patterning parameters, and is performed without regard for the patterning productivity of the patterned substrate; wherein the charged particle inspection system and the one or more processors are further configured to inspect the patterned substrate at candidate defect areas on the patterned substrate in multiple fields and determine which defects repeat across the patterned substrate and thus were enhanced by modulating the patterning parameters. (16)

18. The system of any of the previous clauses, wherein modulating the patterning parameters comprises coating the substrate with a different, higher dose resist compared to a regular production patterning process resist. (16)

19. The system of any of the previous clauses, wherein modulating the patterning parameters comprises varying a dose or focus of exposure illumination associated with the regular production patterning process. (16)

20. The system of any of the previous clauses, wherein modulating the patterning parameters comprises coating the substrate with a different resist compared to a regular production patterning process resist and varying the dose of the exposure illumination associated with the regular production patterning process, and wherein varying the dose comprises increasing the dose relative to a dose used for the regular production patterning process. (19)

21. The system of any of the previous clauses, wherein modulating the patterning parameters comprises providing higher contrast illumination for patterning compared to illumination provided during the regular production patterning process. (16)

22. The system of any of the previous clauses, wherein modulating the patterning parameters comprises varying a pupil fill ratio (PFR) associated with the regular patterning process. (16)

23. The system of any of the previous clauses, wherein the PFR is varied to less than 20%, which causes an illuminator efficiency of the regular patterning process to be less than 100%. (22)

24. The system of any of the previous clauses, wherein the patterning device is a mask, and the regular patterning process is a semiconductor manufacturing process. (16)

25. The system of any of the previous clauses, wherein the charged particle inspection system is a scanning electron microscope (SEM). (16)

26. The system of any of the previous clauses, wherein modulating the patterning parameters to enhance the patternability of the defect in the patterning device onto the patterned substrate comprises modulating the patterning parameters to enhance a likelihood that the defect in the patterning device is patterned onto the patterned substrate relative to a likelihood of patterning the defect in the regular production patterning process. (16)

27. The system of any of the previous clauses, wherein the patterned defects in the patterned substrate associated with the modulated patterning parameters comprise stochastic defects. (16)

28. The system of any of the previous clauses, wherein the patterned substrate is produced with a lithography system associated with the regular production patterning process or a separate lithography system. (16)

29. The system of any of the previous clauses, wherein the patterned substrate is a patterned semiconductor wafer and the defect in the patterning device comprises a particle on the patterning device. (16)

30. The system of any of the previous clauses, wherein the patterned substrate produced using the patterning device and by modulating patterning parameters compared to patterning parameters used during a regular production patterning process is produced using a pattern design and patterning device that are the same as a pattern design and a patterning device used in the regular production patterning process. (16)

31. A non-transitory computer readable medium having instructions thereon, the instructions when executed by a computer, causing operations comprising: inspecting a patterned substrate with a charged particle inspection system, wherein the patterned substrate is produced using a patterning device and by modulating patterning parameters compared to patterning parameters used during a regular production patterning process, and wherein modulating the patterning parameters enhances a patternability of a defect in the patterning device onto the patterned substrate; detecting a defect in the patterned substrate associated with the enhanced patternability of the defect in the patterning device; and detecting the defect in the patterning device based on the defect in the patterned substrate.

32. The medium of clause 31, wherein modulating the patterning parameters enhances the patternability of the defect onto the patterned substrate relative to a patternability of the defect in the regular production patterning process, and balances the enhanced patternability with a quantity of patterned defects in the patterned substrate associated with the modulated patterning parameters, and is performed without regard for a patterning productivity of the patterned substrate; wherein the operations further comprise repeating the inspection at candidate defect areas on the patterned substrate in multiple fields to determine which defects repeat across the patterned substrate and thus were enhanced by modulating the patterning parameters. (31)

33. The medium of any of the previous clauses, wherein modulating the patterning parameters comprises coating the substrate with a different, higher dose resist compared to a regular production patterning process resist. (31)

34. The medium of any of the previous clauses, wherein modulating the patterning parameters comprises varying a dose or focus of exposure illumination associated with the regular production patterning process. (31)

35. The medium of any of the previous clauses, wherein modulating the patterning parameters comprises coating the substrate with a different resist compared to a regular production patterning process resist and varying the dose of the exposure illumination associated with the regular production patterning process, and wherein varying the dose comprises increasing the dose relative to a dose used for the regular production patterning process. (34)

36. The medium of any of the previous clauses, wherein modulating the patterning parameters comprises providing higher contrast illumination for patterning compared to illumination provided during the regular production patterning process. (31)

37. The medium of any of the previous clauses, wherein modulating the patterning parameters comprises varying a pupil fill ratio (PFR) associated with the regular patterning process. (31)

38. The medium of any of the previous clauses, wherein the PFR is varied to less than 20%, which causes an illuminator efficiency of the regular patterning process to be less than 100%. (37)

39. The medium of any of the previous clauses, wherein the patterning device is a mask, and the regular patterning process is a semiconductor manufacturing process. (31)

40. The medium of any of the previous clauses, wherein the charged particle inspection system is a scanning electron microscope (SEM). (31)

41. The medium of any of the previous clauses, wherein modulating the patterning parameters to enhance the patternability of the defect in the patterning device onto the patterned substrate comprises modulating the patterning parameters to enhance a likelihood that the defect in the patterning device is patterned onto the patterned substrate relative to a likelihood of patterning the defect in the regular production patterning process. (31)

42. The medium of any of the previous clauses, wherein the patterned defects in the patterned substrate associated with the modulated patterning parameters comprise stochastic defects. (31)

43. The medium of any of the previous clauses, wherein the patterned substrate is produced with a lithography system associated with the regular production patterning process or a separate lithography system. (31)

44. The medium of any of the previous clauses, wherein the patterned substrate is a patterned semiconductor wafer and the defect in the patterning device comprises a particle on the patterning device. (31)

45. The medium of any of the previous clauses, wherein the patterned substrate produced using the patterning device and by modulating patterning parameters compared to patterning parameters used during a regular production patterning process is produced using a pattern design and patterning device that are the same as a pattern design and a patterning device used in the regular production patterning process. (31)

46. A method for detecting a defect in a patterning device, the method comprising: inspecting a patterned substrate with an inspection system, wherein the patterned substrate is produced using the patterning device and by modulating patterning parameters compared to patterning parameters used during a regular production patterning process, and wherein modulating the patterning parameters enhances a patternability of the defect onto the patterned substrate; detecting a defect in the patterned substrate associated with the enhanced patternability of the defect in the patterning device; and detecting the defect in the patterning device based on the defect in the patterned substrate.

47. The method of any of the previous clauses, wherein modulating the patterning parameters enhances the patternability of the defect onto the patterned substrate relative to a patternability of the defect in the regular production patterning process, and balances the enhanced patternability with a quantity of patterned defects in the patterned substrate associated with the modulated patterning parameters, and is performed without regard for a patterning productivity of the patterned substrate; wherein the method further comprises repeating the inspection at candidate defect areas on the patterned substrate in multiple fields to determine which defects repeat across the patterned substrate and thus were enhanced by modulating the patterning parameters. (46)

48. The method of any of the previous clauses, wherein modulating the patterning parameters comprises coating the substrate with a different, higher dose resist compared to a regular production patterning process resist. (46)

49. The method of any of the previous clauses, wherein modulating the patterning parameters comprises varying a dose or focus of exposure illumination associated with the regular production patterning process. (46)

50. The method of any of the previous clauses, wherein modulating the patterning parameters comprises coating the substrate with a different resist compared to a regular production patterning process resist and varying the dose of the exposure illumination associated with the regular production patterning process, and wherein varying the dose comprises increasing the dose relative to a dose used for the regular production patterning process. (49)

51. The method of any of the previous clauses, wherein modulating the patterning parameters comprises providing higher contrast illumination for patterning compared to illumination provided during the regular production patterning process. (46)

52. The method of any of the previous clauses, wherein modulating the patterning parameters comprises varying a pupil fill ratio (PFR) associated with the regular patterning process. (46)

53. The method of any of the previous clauses, wherein the PFR is varied to less than 20%, which causes an illuminator efficiency of the regular patterning process to be less than 100%. (46)

54. The method of any of the previous clauses, wherein the patterning device is a mask, and the regular patterning process is a semiconductor manufacturing process. (46)

55. The method of any of the previous clauses, wherein the inspection system is a charged particle inspection system or an optical inspection system. (46)

56. The method of any of the previous clauses, wherein modulating the patterning parameters to enhance the patternability of the defect in the patterning device onto the patterned substrate comprises modulating the patterning parameters to enhance a likelihood that the defect in the patterning device is patterned onto the patterned substrate relative to a likelihood of patterning the defect in the regular production patterning process. (46)

57. The method of any of the previous clauses, wherein the patterned defects in the patterned substrate associated with the modulated patterning parameters comprise stochastic defects. (46)

58. The method of any of the previous clauses, wherein the patterned substrate is produced with a lithography system associated with the regular production patterning process or a separate lithography system. (46)

59. The method of any of the previous clauses, wherein the patterned substrate is a patterned semiconductor wafer and the defect in the patterning device comprises a particle on the patterning device. (46)

60. The method of any of the previous clauses, wherein the patterned substrate produced using the patterning device and by modulating patterning parameters compared to patterning parameters used during a regular production patterning process is produced using a pattern design and patterning device that are the same as a pattern design and a patterning device used in the regular production patterning process. (46)

61. A system for detecting a defect in a patterning device, the system comprising: an inspection system configured for inspecting a patterned substrate, wherein the patterned substrate is produced using the patterning device and by modulating patterning parameters compared to patterning parameters used during a regular production patterning process, and wherein modulating the patterning parameters enhances a patternability of a defect in the patterning device onto the patterned substrate; and one or more processors configured by machine readable instructions to: detect a defect in the patterned substrate associated with the enhanced patternability of the defect in the patterning device; and detect the defect in the patterning device based on the defect in the patterned substrate.

62. The system of any of the previous clauses, wherein modulating the patterning parameters enhances the patternability of the defect onto the patterned substrate relative to a patternability of the defect in the regular production patterning process, and balances the enhanced patternability with a quantity of patterned defects in the patterned substrate associated with the modulated patterning parameters, and is performed without regard for a patterning productivity of the patterned substrate; wherein the inspection system and the one or more processors are configured to repeat the inspection at candidate defect areas on the patterned substrate in multiple fields to determine which defects repeat across the patterned substrate and thus were enhanced by modulating the patterning parameters. (61)

63. The system of any of the previous clauses, wherein modulating the patterning parameters comprises coating the substrate with a different, higher dose resist compared to a regular production patterning process resist. (61)

64. The system of any of the previous clauses, wherein modulating the patterning parameters comprises varying a dose or focus of exposure illumination associated with the regular production patterning process. (61)

65. The system of any of the previous clauses, wherein modulating the patterning parameters comprises coating the substrate with a different resist compared to a regular production patterning process resist and varying the dose of the exposure illumination associated with the regular production patterning process, and wherein varying the dose comprises increasing the dose relative to a dose used for the regular production patterning process. (64)

66. The system of any of the previous clauses, wherein modulating the patterning parameters comprises providing higher contrast illumination for patterning compared to illumination provided during the regular production patterning process. (61)

67. The system of any of the previous clauses, wherein modulating the patterning parameters comprises varying a pupil fill ratio (PFR) associated with the regular patterning process. (61)

68. The system of claim 67, wherein the PFR is varied to less than 20%, which causes an illuminator efficiency of the regular patterning process to be less than 100%. (61)

69. The system of any of the previous clauses, wherein the patterning device is a mask, and the regular patterning process is a semiconductor manufacturing process. (61)

70. The system of any of the previous clauses, wherein the inspection system is a charged particle inspection system or an optical inspection system. (61)

71. The system of any of claims any of the previous clauses, wherein modulating the patterning parameters to enhance the patternability of the defect in the patterning device onto the patterned substrate comprises modulating the patterning parameters to enhance a likelihood that the defect in the patterning device is patterned onto the patterned substrate relative to a likelihood of patterning the defect in the regular production patterning process. (61)

72. The system of any of the previous clauses, wherein the patterned defects in the patterned substrate associated with the modulated patterning parameters comprise stochastic defects. (61)

73. The system of any of the previous clauses, wherein the patterned substrate is produced with a lithography system associated with the regular production patterning process or a separate lithography system. (61)

74. The system of any of the previous clauses, wherein the patterned substrate is a patterned semiconductor wafer and the defect in the patterning device comprises a particle on the patterning device. (61)

75. The system of any of the previous clauses, wherein the patterned substrate produced using the patterning device and by modulating patterning parameters compared to patterning parameters used during a regular production patterning process is produced using a pattern design and patterning device that are the same as a pattern design and a patterning device used in the regular production patterning process. (61)

76. A non-transitory computer readable medium having instructions thereon, the instructions when executed by a computer, causing operations comprising: inspecting a patterned substrate with an inspection system, wherein the patterned substrate is produced using a patterning device and by modulating patterning parameters compared to patterning parameters used during a regular production patterning process, and wherein modulating the patterning parameters enhances a patternability of a defect in the patterning device onto the patterned substrate; detecting a defect in the patterned substrate associated with the enhanced patternability of the defect in the patterning device; and detecting the defect in the patterning device based on the defect in the patterned substrate.

77. The medium of any of the previous clauses, wherein modulating the patterning parameters enhances the patternability of the defect onto the patterned substrate relative to a patternability of the defect in the regular production patterning process, and balances the enhanced patternability with a quantity of patterned defects in the patterned substrate associated with the modulated patterning parameters, and is performed without regard for a patterning productivity of the patterned substrate; wherein the operations further comprise repeating the inspection at candidate defect areas on the patterned substrate in multiple fields to determine which defects repeat across the patterned substrate and thus were enhanced by modulating the patterning parameters. (76)

78. The medium of any of the previous clauses, wherein modulating the patterning parameters comprises coating the substrate with a different, higher dose resist compared to a regular production patterning process resist. (76)

79. The medium of any of the previous clauses, wherein modulating the patterning parameters comprises varying a dose or focus of exposure illumination associated with the regular production patterning process. (76)

80. The medium of any of the previous clauses, wherein modulating the patterning parameters comprises coating the substrate with a different resist compared to a regular production patterning process resist and varying the dose of the exposure illumination associated with the regular production patterning process, and wherein varying the dose comprises increasing the dose relative to a dose used for the regular production patterning process. (79)

81. The medium of any of the previous clauses, wherein modulating the patterning parameters comprises providing higher contrast illumination for patterning compared to illumination provided during the regular production patterning process. (76)

82. The medium of any of the previous clauses, wherein modulating the patterning parameters comprises varying a pupil fill ratio (PFR) associated with the regular patterning process. (76)

83. The medium of any of the previous clauses, wherein the PFR is varied to less than 20%, which causes an illuminator efficiency of the regular patterning process to be less than 100%. (76)

84. The medium of any of the previous clauses, wherein the patterning device is a mask, and the regular patterning process is a semiconductor manufacturing process. (76)

85. The medium of any of the previous clauses, wherein the inspection system is a charged particle inspection system or an optical inspection system. (76)

86. The medium of any of the previous clauses, wherein modulating the patterning parameters to enhance the patternability of the defect in the patterning device onto the patterned substrate comprises modulating the patterning parameters to enhance a likelihood that the defect in the patterning device is patterned onto the patterned substrate relative to a likelihood of patterning the defect in the regular production patterning process. (76)

87. The medium of any of the previous clauses, wherein the patterned defects in the patterned substrate associated with the modulated patterning parameters comprise stochastic defects. (76)

88. The medium of any of the previous clauses, wherein the patterned substrate is produced with a lithography system associated with the regular production patterning process or a separate lithography system. (76)

89. The medium of any of the previous clauses, wherein the patterned substrate is a patterned semiconductor wafer and the defect in the patterning device comprises a particle on the patterning device. (76)

90. The medium of any of the previous clauses, wherein the patterned substrate produced using the patterning device and by modulating patterning parameters compared to patterning parameters used during a regular production patterning process is produced using a pattern design and patterning device that are the same as a pattern design and a patterning device used in the regular production patterning process. (76)

91. A method for enhancing patterning of a defect in a patterning device onto a substrate, the method comprising: modulating patterning parameters of a regular production patterning process, wherein modulating the patterning parameters enhances a patternability of the defect in the patterning device onto the substrate compared to a patternability of the defect in the regular production patterning process; and patterning the defect in the patterning device onto the substrate using modulated patterning parameters; wherein, after patterning with the modulated patterning parameters, and because of the enhanced patternability of the defect balanced with the quantity of patterned defects associated with the modulated patterning parameters, the substrate is configured for inspection with a charged particle inspection system.

92. The method of any of the previous clauses, wherein modulating the patterning parameters enhances the patternability of the defect onto the patterned substrate relative to a patternability of the defect in the regular production patterning process, and balances the enhanced patternability with a quantity of patterned defects in the patterned substrate associated with the modulated patterning parameters, and is performed without regard for a patterning productivity of the patterned substrate; wherein the method further comprises inspecting the substrate at candidate defect areas on the substrate in multiple fields to determine which defects repeat across the substrate and thus were enhanced by modulating the patterning parameters. (91)

93. The method of any of the previous clauses, wherein modulating the patterning parameters comprises coating the substrate with a different, higher dose resist compared to a regular production patterning process resist. (91)

94. The method of any of the previous clauses, wherein modulating the patterning parameters comprises varying a dose or focus of exposure illumination associated with the regular production patterning process. (91)

95. The method of any of the previous clauses, wherein modulating the patterning parameters comprises coating the substrate with a different resist compared to a regular production patterning process resist and varying the dose of the exposure illumination associated with the regular production patterning process, and wherein varying the dose comprises increasing the dose relative to a dose used for the regular production patterning process. (94)

96. The method of any of the previous clauses, wherein modulating the patterning parameters comprises providing higher contrast illumination for patterning compared to illumination provided during the regular production patterning process. (91)

97. The method of any of the previous clauses, wherein modulating the patterning parameters comprises varying a pupil fill ratio (PFR) associated with the regular patterning process. (91)

98. The method of any of the previous clauses, wherein the PFR is varied to less than 20%, which causes an illuminator efficiency of the regular patterning process to be less than 100%. (97)

99. The method of any of the previous clauses, wherein the patterning device is a mask, and the regular patterning process is a semiconductor manufacturing process. (91)

100. The method of any of the previous clauses, wherein the charged particle inspection system is a scanning electron microscope (SEM). (91)

101. The method of any of the previous clauses, wherein modulating the patterning parameters to enhance the patternability of the defect in the patterning device onto the patterned substrate comprises modulating the patterning parameters to enhance a likelihood that the defect in the patterning device is patterned onto the patterned substrate relative to a likelihood of patterning the defect in the regular production patterning process. (91)

102. The method of any of the previous clauses, wherein the patterned defects in the patterned substrate associated with the modulated patterning parameters comprise stochastic defects. (91)

103. The method of any of the previous clauses, wherein the patterned substrate is produced with a lithography system associated with the regular production patterning process or a separate lithography system. (91)

104. The method of any of the previous clauses, wherein the patterned substrate is a patterned semiconductor wafer and the defect in the patterning device comprises a particle on the patterning device. (91)

105. The method of any of the previous clauses, wherein the patterned substrate produced using the patterning device and by modulating patterning parameters compared to patterning parameters used during a regular production patterning process is produced using a pattern design and patterning device that are the same as a pattern design and a patterning device used in the regular production patterning process. (91)

106. A system for enhancing patterning of a defect in a patterning device onto a substrate, the system comprising: one or more processors configured by machine readable instruction to modulate patterning parameters of a regular production patterning process, wherein modulating the patterning parameters enhances a patternability of the defect in the patterning device onto the substrate compared to a patternability of the defect in the regular production patterning process; and a patterning system configured for patterning the defect in the patterning device onto the substrate using modulated patterning parameters; wherein, after patterning with the modulated patterning parameters, and because of the enhanced patternability of the defect balanced with the quantity of patterned defects associated with the modulated patterning parameters, the substrate is configured for inspection with a charged particle inspection system.

107. The system of any of the previous clauses, wherein modulating the patterning parameters enhances the patternability of the defect onto the patterned substrate relative to a patternability of the defect in the regular production patterning process, and balances the enhanced patternability with a quantity of patterned defects in the patterned substrate associated with the modulated patterning parameters, and is performed without regard for a patterning productivity of the patterned substrate; wherein the system further comprises the charged particle inspection system configured for inspecting the substrate at candidate defect areas on the substrate in multiple fields to determine which defects repeat across the substrate and thus were enhanced by modulating the patterning parameters. (106)

108. The system of any of the previous clauses, wherein modulating the patterning parameters comprises coating the substrate with a different, higher dose resist compared to a regular production patterning process resist. (106)

109. The system of any of the previous clauses, wherein modulating the patterning parameters comprises varying a dose or focus of exposure illumination associated with the regular production patterning process. (106)

110. The system of any of the previous clauses, wherein modulating the patterning parameters comprises coating the substrate with a different resist compared to a regular production patterning process resist and varying the dose of the exposure illumination associated with the regular production patterning process, and wherein varying the dose comprises increasing the dose relative to a dose used for the regular production patterning process. (109)

111. The system of any of the previous clauses, wherein modulating the patterning parameters comprises providing higher contrast illumination for patterning compared to illumination provided during the regular production patterning process. (106)

112. The system of any of the previous clauses, wherein modulating the patterning parameters comprises varying a pupil fill ratio (PFR) associated with the regular patterning process. (106)

113. The system of any of the previous clauses, wherein the PFR is varied to less than 20%, which causes an illuminator efficiency of the regular patterning process to be less than 100%. (106)

114. The system of any of the previous clauses, wherein the patterning device is a mask, and the regular patterning process is a semiconductor manufacturing process. (106)

115. The system of any of the previous clauses, wherein the charged particle inspection system is a scanning electron microscope (SEM). (106)

116. The system of any of the previous clauses, wherein modulating the patterning parameters to enhance the patternability of the defect in the patterning device onto the patterned substrate comprises modulating the patterning parameters to enhance a likelihood that the defect in the patterning device is patterned onto the patterned substrate relative to a likelihood of patterning the defect in the regular production patterning process. (106)

117. The system of any of the previous clauses, wherein the patterned defects in the patterned substrate associated with the modulated patterning parameters comprise stochastic defects. (106)

118. The system of any of the previous clauses, wherein the patterned substrate is produced with a lithography system associated with the regular production patterning process or a separate lithography system. (106)

119. The system of any of the previous clauses, wherein the patterned substrate is a patterned semiconductor wafer and the defect in the patterning device comprises a particle on the patterning device. (106)

120. The system of any of the previous clauses, wherein the patterned substrate produced using the patterning device and by modulating patterning parameters compared to patterning parameters used during a regular production patterning process is produced using a pattern design and patterning device that are the same as a pattern design and a patterning device used in the regular production patterning process. (106)

121. A non-transitory computer readable medium having instructions thereon, the instructions when executed by a computer, causing operations comprising: modulating patterning parameters of a regular production patterning process, wherein modulating the patterning parameters enhances a patternability of a defect in a patterning device onto a substrate compared to a patternability of the defect in the regular production patterning process; and patterning the defect in the patterning device onto the substrate using modulated patterning parameters; wherein, after patterning with the modulated patterning parameters, and because of the enhanced patternability of the defect balanced with the quantity of patterned defects associated with the modulated patterning parameters, the substrate is configured for inspection with a charged particle inspection system.

122. The medium of any of the previous clauses, wherein modulating the patterning parameters enhances the patternability of the defect onto the patterned substrate relative to a patternability of the defect in the regular production patterning process, and balances the enhanced patternability with a quantity of patterned defects in the patterned substrate associated with the modulated patterning parameters, and is performed without regard for a patterning productivity of the patterned substrate; wherein the method further comprises inspecting the substrate at candidate defect areas on the substrate in multiple fields to determine which defects repeat across the substrate and thus were enhanced by modulating the patterning parameters. (121)

123. The medium of any of the previous clauses, wherein modulating the patterning parameters comprises coating the substrate with a different, higher dose resist compared to a regular production patterning process resist. (121)

124. The medium of any of the previous clauses, wherein modulating the patterning parameters comprises varying a dose or focus of exposure illumination associated with the regular production patterning process. (121)

125. The medium of any of the previous clauses, wherein modulating the patterning parameters comprises coating the substrate with a different resist compared to a regular production patterning process resist and varying the dose of the exposure illumination associated with the regular production patterning process, and wherein varying the dose comprises increasing the dose relative to a dose used for the regular production patterning process. (121)

126. The medium of any of the previous clauses, wherein modulating the patterning parameters comprises providing higher contrast illumination for patterning compared to illumination provided during the regular production patterning process. (121)

127. The medium of any of the previous clauses, wherein modulating the patterning parameters comprises varying a pupil fill ratio (PFR) associated with the regular patterning process. (121)

128. The medium of any of the previous clauses, wherein the PFR is varied to less than 20%, which causes an illuminator efficiency of the regular patterning process to be less than 100%. (127)

129. The medium of any of the previous clauses, wherein the patterning device is a mask, and the regular patterning process is a semiconductor manufacturing process. (121)

130. The medium of any of the previous clauses, wherein the charged particle inspection system is a scanning electron microscope (SEM). (121)

131. The medium of any of the previous clauses, wherein modulating the patterning parameters to enhance the patternability of the defect in the patterning device onto the patterned substrate comprises modulating the patterning parameters to enhance a likelihood that the defect in the patterning device is patterned onto the patterned substrate relative to a likelihood of patterning the defect in the regular production patterning process. (121)

132. The medium of any of the previous clauses, wherein the patterned defects in the patterned substrate associated with the modulated patterning parameters comprise stochastic defects. (121)

133. The medium of any of the previous clauses, wherein the patterned substrate is produced with a lithography system associated with the regular production patterning process or a separate lithography system. (121)

134. The medium of any of the previous clauses, wherein the patterned substrate is a patterned semiconductor wafer and the defect in the patterning device comprises a particle on the patterning device. (121)

135. The medium of any of the previous clauses, wherein the patterned substrate produced using the patterning device and by modulating patterning parameters compared to patterning parameters used during a regular production patterning process is produced using a pattern design and patterning device that are the same as a pattern design and a patterning device used in the regular production patterning process. (121)

136. A method for detecting a defect in a patterning device, the method comprising: inspecting a patterned substrate with a charged particle inspection system, wherein the patterned substrate is produced using the patterning device and by modulating patterning parameters compared to patterning parameters used during a regular production patterning process, and wherein modulating the patterning parameters enhances a patternability of the defect onto the patterned substrate; detecting a defect in the patterned substrate associated with the enhanced patternability of the defect in the patterning device; and detecting the defect in the patterning device based on the defect in the patterned substrate.

137. The method of any of the previous clauses, wherein modulating the patterning parameters enhances the patternability of the defect onto the patterned substrate relative to a patternability of the defect in the regular production patterning process, and balances the enhanced patternability with a quantity of patterned defects in the patterned substrate associated with the modulated patterning parameters, and is performed without regard for the patterning productivity of the patterned substrate; wherein the method further comprises repeating the inspection at candidate defect areas on the patterned substrate in multiple fields to determine which defects repeat across the patterned substrate and thus were enhanced by modulating the patterning parameters. (136)

138. The method of any of the previous clauses, wherein modulating the patterning parameters comprises coating the substrate with a different, higher dose resist compared to a regular production patterning process resist. (136)

139. The method of any of the previous clauses, wherein modulating the patterning parameters comprises varying a dose or focus of exposure illumination associated with the regular production patterning process. (136)

140. The method of any of the previous clauses, wherein modulating the patterning parameters comprises coating the substrate with a different resist compared to a regular production patterning process resist and varying the dose of the exposure illumination associated with the regular production patterning process, and wherein varying the dose comprises increasing the dose relative to a dose used for the regular production patterning process. (139)

141. The method of any of the previous clauses, wherein modulating the patterning parameters comprises providing higher contrast illumination for patterning compared to illumination provided during the regular production patterning process. (136)

142. The method of any of the previous clauses, wherein modulating the patterning parameters comprises varying a pupil fill ratio (PFR) associated with the regular patterning process. (136)

143. The method of any of the previous clauses, wherein the PFR is varied to less than 20%, which causes an illuminator efficiency of the regular patterning process to be less than 100%. (136)

144. The method of any of the previous clauses, wherein the patterning device is a mask, and the regular patterning process is a semiconductor manufacturing process. (136)

145. The method of any of the previous clauses, wherein the charged particle inspection system is a scanning electron microscope (SEM). (136)

146. The method of any of the previous clauses, wherein modulating the patterning parameters to enhance the patternability of the defect in the patterning device onto the patterned substrate comprises modulating the patterning parameters to enhance a likelihood that the defect in the patterning device is patterned onto the patterned substrate relative to a likelihood of patterning the defect in the regular production patterning process. (136)

147. The method of any of the previous clauses, wherein the patterned defects in the patterned substrate associated with the modulated patterning parameters comprise stochastic defects. (136)

148. The method of any of the previous clauses, wherein the patterned substrate is produced with a lithography system associated with the regular production patterning process or a separate lithography system. (136)

149. The method of any of the previous clauses, wherein the patterned substrate is a patterned semiconductor wafer and the defect in the patterning device comprises a particle on the patterning device. (136)

150. The method of any of the previous clauses, wherein the patterned substrate produced using the patterning device and by modulating patterning parameters compared to patterning parameters used during a regular production patterning process is produced using a pattern design and patterning device that are the same as a pattern design and a patterning device used in the regular production patterning process. (136)

151. A system for detecting a defect in a patterning device, the system comprising: a charged particle inspection system configured for inspecting a patterned substrate, wherein the patterned substrate is produced using the patterning device and by modulating patterning parameters compared to patterning parameters used during a regular production patterning process, and wherein modulating the patterning parameters enhances a patternability of the defect onto the patterned substrate; and one or more processors configured by machine readable instructions to: detect a defect in the patterned substrate associated with the enhanced patternability of the defect in the patterning device; and detect the defect in the patterning device based on the defect in the patterned substrate.

152. The system of any of the previous clauses, wherein modulating the patterning parameters enhances the patternability of the defect onto the patterned substrate relative to a patternability of the defect in the regular production patterning process, and balances the enhanced patternability with a quantity of patterned defects in the patterned substrate associated with the modulated patterning parameters, and is performed without regard for the patterning productivity of the patterned substrate; wherein the charged particle inspection system and the one or more processors are further configured to inspect the patterned substrate at candidate defect areas on the patterned substrate in multiple fields and determine which defects repeat across the patterned substrate and thus were enhanced by modulating the patterning parameters. (151)

153. The system of any of the previous clauses, wherein modulating the patterning parameters comprises coating the substrate with a different, higher dose resist compared to a regular production patterning process resist. (151)

154. The system of any of the previous clauses, wherein modulating the patterning parameters comprises varying a dose or focus of exposure illumination associated with the regular production patterning process. (151)

155. The system of any of the previous clauses, wherein modulating the patterning parameters comprises coating the substrate with a different resist compared to a regular production patterning process resist and varying the dose of the exposure illumination associated with the regular production patterning process, and wherein varying the dose comprises increasing the dose relative to a dose used for the regular production patterning process. (154)

156. The system of any of the previous clauses, wherein modulating the patterning parameters comprises providing higher contrast illumination for patterning compared to illumination provided during the regular production patterning process. (151)

157. The system of any of the previous clauses, wherein modulating the patterning parameters comprises varying a pupil fill ratio (PFR) associated with the regular patterning process. (151)

158. The system of any of the previous clauses, wherein the PFR is varied to less than 20%, which causes an illuminator efficiency of the regular patterning process to be less than 100%. (151)

159. The system of any of the previous clauses, wherein the patterning device is a mask, and the regular patterning process is a semiconductor manufacturing process. (151)

160. The system of any of the previous clauses, wherein the charged particle inspection system is a scanning electron microscope (SEM). (151)

161. The system of any of the previous clauses, wherein modulating the patterning parameters to enhance the patternability of the defect in the patterning device onto the patterned substrate comprises modulating the patterning parameters to enhance a likelihood that the defect in the patterning device is patterned onto the patterned substrate relative to a likelihood of patterning the defect in the regular production patterning process. (151)

162. The system of any of the previous clauses, wherein the patterned defects in the patterned substrate associated with the modulated patterning parameters comprise stochastic defects. (151)

163. The system of any of the previous clauses, wherein the patterned substrate is produced with a lithography system associated with the regular production patterning process or a separate lithography system. (151)

164. The system of any of the previous clauses, wherein the patterned substrate is a patterned semiconductor wafer and the defect in the patterning device comprises a particle on the patterning device. (151)

165. The system of any of the previous clauses, wherein the patterned substrate produced using the patterning device and by modulating patterning parameters compared to patterning parameters used during a regular production patterning process is produced using a pattern design and patterning device that are the same as a pattern design and a patterning device used in the regular production patterning process. (151)

166. A non-transitory computer readable medium having instructions thereon, the instructions when executed by a computer, causing operations comprising: inspecting a patterned substrate with a charged particle inspection system, wherein the patterned substrate is produced using a patterning device and by modulating patterning parameters compared to patterning parameters used during a regular production patterning process, and wherein modulating the patterning parameters enhances a patternability of a defect in the patterning device onto the patterned substrate; detecting a defect in the patterned substrate associated with the enhanced patternability of the defect in the patterning device; and detecting the defect in the patterning device based on the defect in the patterned substrate.

167. The medium of any of the previous clauses, wherein modulating the patterning parameters enhances the patternability of the defect onto the patterned substrate relative to a patternability of the defect in the regular production patterning process, and balances the enhanced patternability with a quantity of patterned defects in the patterned substrate associated with the modulated patterning parameters, and is performed without regard for the patterning productivity of the patterned substrate; wherein the operations further comprise repeating the inspection at candidate defect areas on the patterned substrate in multiple fields to determine which defects repeat across the patterned substrate and thus were enhanced by modulating the patterning parameters. (166)

168. The medium of any of the previous clauses, wherein modulating the patterning parameters comprises coating the substrate with a different, higher dose resist compared to a regular production patterning process resist. (166)

169. The medium of any of the previous clauses, wherein modulating the patterning parameters comprises varying a dose or focus of exposure illumination associated with the regular production patterning process. (166)

170. The medium of any of the previous clauses, wherein modulating the patterning parameters comprises coating the substrate with a different resist compared to a regular production patterning process resist and varying the dose of the exposure illumination associated with the regular production patterning process, and wherein varying the dose comprises increasing the dose relative to a dose used for the regular production patterning process. (169)

171. The medium of any of the previous clauses, wherein modulating the patterning parameters comprises providing higher contrast illumination for patterning compared to illumination provided during the regular production patterning process. (166)

172. The medium of any of the previous clauses, wherein modulating the patterning parameters comprises varying a pupil fill ratio (PFR) associated with the regular patterning process. (166)

173. The medium of any of the previous clauses, wherein the PFR is varied to less than 20%, which causes an illuminator efficiency of the regular patterning process to be less than 100%. (166)

174. The medium of any of the previous clauses, wherein the patterning device is a mask, and the regular patterning process is a semiconductor manufacturing process. (166)

175. The medium of any of the previous clauses, wherein the charged particle inspection system is a scanning electron microscope (SEM). (166)

176. The medium of any of the previous clauses, wherein modulating the patterning parameters to enhance the patternability of the defect in the patterning device onto the patterned substrate comprises modulating the patterning parameters to enhance a likelihood that the defect in the patterning device is patterned onto the patterned substrate relative to a likelihood of patterning the defect in the regular production patterning process. (166)

177. The medium of any of the previous clauses, wherein the patterned defects in the patterned substrate associated with the modulated patterning parameters comprise stochastic defects. (166)

178. The medium of any of the previous clauses, wherein the patterned substrate is produced with a lithography system associated with the regular production patterning process or a separate lithography system. (166)

179. The medium of any of the previous clauses, wherein the patterned substrate is a patterned semiconductor wafer and the defect in the patterning device comprises a particle on the patterning device. (166)

180. The medium of any of the previous clauses, wherein the patterned substrate produced using the patterning device and by modulating patterning parameters compared to patterning parameters used during a regular production patterning process is produced using a pattern design and patterning device that are the same as a pattern design and a patterning device used in the regular production patterning process. (166)

181. A non-transitory computer readable medium having instructions thereon, the instructions when executed by a computer, causing the computer to detect a defect in a mask used in a semiconductor manufacturing process, the detection performed on a defect enhanced non-production patterned semiconductor wafer without regard for the patterning productivity of the patterned substrate, the instructions causing operations comprising: inspecting the patterned semiconductor wafer with a charged particle inspection system, wherein: the patterned semiconductor wafer is produced using the mask and by modulating patterning parameters compared to patterning parameters used during a regular semiconductor manufacturing patterning process; and modulating the patterning parameters is configured to enhance a patternability of the defect in the mask onto the patterned semiconductor wafer and balance the enhanced patternability with a quantity of patterned defects in the patterned semiconductor wafer associated with the modulated patterning parameters; detecting a defect in the patterned semiconductor wafer associated with the enhanced patternability of the defect in the mask; and detecting the defect in the mask based on the defect in the patterned semiconductor wafer.

182. The medium of any of the previous clauses, wherein modulating the patterning parameters comprises coating the semiconductor wafer with a different, higher dose resist compared to a regular semiconductor manufacturing process resist, and varying a dose or focus of exposure illumination associated with the regular semiconductor manufacturing process based on the higher dose resist. (181)

183. The medium of any of the previous clauses, wherein modulating the patterning parameters comprises providing higher contrast illumination for patterning compared to illumination provided during the regular semiconductor manufacturing process, the higher contrast illumination provided by varying a pupil fill ratio (PFR) associated with the semiconductor manufacturing process to less than 20%, which causes an illuminator efficiency of the semiconductor manufacturing process to be less than 100%. (181)

184. The medium of any of the previous clauses, wherein the charged particle inspection system is a scanning electron microscope (SEM). (181)

185. The medium of any of the previous clauses, wherein modulating the patterning parameters to enhance the patternability of the defect in the mask onto the patterned semiconductor wafer comprises modulating the patterning parameters to enhance a likelihood that the defect in the mask is patterned onto the semiconductor wafer relative to a likelihood of patterning the defect in the regular production patterning process. (181)

The concepts disclosed herein may be used with any imaging, etching, polishing, inspection, etc. system for sub wavelength features, and may be useful with emerging imaging technologies capable of producing increasingly shorter wavelengths. Emerging technologies include EUV (extreme ultra violet), DUV lithography that is capable of producing a 193nm wavelength with the use of an ArF laser, and even a 157nm wavelength with the use of a Fluorine laser. Moreover, EUV lithography is capable of producing wavelengths within a range of 20-50nm by using a synchrotron or by hitting a material (either solid or a plasma) with high energy electrons in order to produce photons within this range.

While the concepts disclosed herein may be used for manufacturing with a substrate such as a silicon wafer, it shall be understood that the disclosed concepts may be used with any type of manufacturing system (e.g., those used for manufacturing on substrates other than silicon wafers).

In addition, the combination and sub-combinations of disclosed elements may comprise separate embodiments. For example, the point level and feature level filtering described herein may be included in separate embodiments, or they may be included together in the same embodiment.

The descriptions above are intended to be illustrative, not limiting. Thus, it will be apparent to one skilled in the art that modifications may be made as described without departing from the scope of the claims set out below.

As used herein, unless specifically stated otherwise, the term "or" encompasses all possible combinations, except where infeasible. For example, if it is stated that a component may include A or B, then, unless specifically stated otherwise or infeasible, the component may include A, or B, or A and B. As a second example, if it is stated that a component may include A, B, or C, then, unless specifically stated otherwise or infeasible, the component may include A, or B, or C, or A and B, or A and C, or B and C, or A and B and C.

## Claims

1. A system for detecting a defect in a patterning device, the system comprising:

   a charged particle inspection system configured for inspecting a patterned substrate, wherein the patterned substrate is produced using the patterning device and by modulating patterning parameters compared to patterning parameters used during a regular production patterning process, and wherein modulating the patterning parameters enhances a patternability of the defect onto the patterned substrate; and
   one or more processors configured by machine readable instructions to:

      detect a defect in the patterned substrate associated with the enhanced patternability of the defect in the patterning device; and
      detect the defect in the patterning device based on the defect in the patterned substrate.

2. The system of claim 1, wherein modulating the patterning parameters enhances the patternability of the defect onto the patterned substrate relative to a patternability of the defect in the regular production patterning process, and balances the enhanced patternability with a quantity of patterned defects in the patterned substrate associated with the modulated patterning parameters, and is performed without regard for a patterning productivity of the patterned substrate;
   wherein the charged particle inspection system and the one or more processors are further configured to inspect the patterned substrate at candidate defect areas on the patterned substrate in multiple fields and determine which defects repeat across the patterned substrate and thus were enhanced by modulating the patterning parameters.

3. The system of claim 1, wherein modulating the patterning parameters comprises coating the substrate with a different, higher dose resist compared to a regular production patterning process resist.

4. The system of claim 1, wherein modulating the patterning parameters comprises varying a dose or focus of exposure illumination associated with the regular production patterning process.

5. The system of claim 4, wherein modulating the patterning parameters comprises coating the substrate with a different resist compared to a regular production patterning process resist and varying the dose of the exposure illumination associated with the regular production patterning process, and wherein varying the dose comprises increasing the dose relative to a dose used for the regular production patterning process.

6. The system of claim 1, wherein modulating the patterning parameters comprises providing higher contrast illumination for patterning compared to illumination provided during the regular production patterning process.

7. The system of claim 1, wherein modulating the patterning parameters comprises varying a pupil fill ratio (PFR) associated with the regular patterning process.

8. The system of claim 7, wherein the PFR is varied to less than 20%, which causes an illuminator efficiency of the regular patterning process to be less than 100%.

9. The system of claim 1, wherein the patterning device is a mask, and the regular patterning process is a semiconductor manufacturing process.

10. The system of claim 1, wherein the charged particle inspection system is a scanning electron microscope (SEM), the patterned substrate is a patterned semiconductor wafer, and the defect in the patterning device comprises a particle on the patterning device.

11. The system of claim 1, wherein modulating the patterning parameters to enhance the patternability of the defect in the patterning device onto the patterned substrate comprises modulating the patterning parameters to enhance a likelihood that the defect in the patterning device is patterned onto the patterned substrate relative to a likelihood of patterning the defect in the regular production patterning process.

12. The system of claim 1, wherein the patterned defects in the patterned substrate associated with the modulated patterning parameters comprise stochastic defects.

**13.** The system of claim 1, wherein the patterned substrate is produced with a lithography system associated with the regular production patterning process or a separate lithography system.

**14.** The system of claim 1, wherein the patterned substrate produced using the patterning device and by modulating patterning parameters compared to patterning parameters used during a regular production patterning process is produced using a pattern design and patterning device that are the same as a pattern design and a patterning device used in the regular production patterning process.

**15.** A non-transitory computer readable medium having instructions thereon, the instructions when executed by a computer, causing operations comprising:

   inspecting a patterned substrate with a charged particle inspection system, wherein the patterned substrate is produced using a patterning device and by modulating patterning parameters compared to patterning parameters used during a regular production patterning process, and wherein modulating the patterning parameters enhances a patternability of a defect in the patterning device onto the patterned substrate;
   detecting a defect in the patterned substrate associated with the enhanced patternability of the defect in the patterning device; and
   detecting the defect in the patterning device based on the defect in the patterned substrate.

**FIG. 1**

FIG. 2

**FIG. 3**

**FIG. 4**

FIG. 5

600

602

604

606

608

FIG. 6

**FIG. 7**

**FIG. 8**

900

902

904

906

FIG. 9A

901

903

905

907

909

FIG. 9B

**FIG. 10**

FIG. 11

**FIG. 12**

FIG. 13

Europäisches
Patentamt

European
Patent Office

Office européen
des brevets

# EUROPEAN SEARCH REPORT

**Application Number**

EP 21 19 5866

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2010/142800 A1 (TUNG-SING PAK PATRICK [SG] ET AL) 10 June 2010 (2010-06-10) | 1,2,4,9, 11-15 | INV. G03F1/84 |
| Y | * paragraphs [0020] - [0023] * <br> * paragraphs [0056] - [0069]; figures 1-4 * <br> * paragraphs [0085] - [0089]; figure 5 * | 10 | G01N21/956 G03F7/20 G06T7/00 |
| X | US 2009/016595 A1 (PETERSON INGRID B [US] ET AL) 15 January 2009 (2009-01-15) | 1,2,4, 6-9,11, 13-15 | |
| Y | * paragraphs [0003] - [0009] * <br> * paragraphs [0056] - [0064]; figures 3-12 * <br> * paragraphs [0138] - [0141]; figure 25 * | 10 | |
| X | JP H09 211840 A (MATSUSHITA ELECTRIC IND CO LTD) 15 August 1997 (1997-08-15) | 1,2,4,9, 11,13-15 | |
| Y | * paragraphs [0038] - [0054]; figures 1-4 * <br> * paragraph [0067] * | 3,5 | |
| Y | US 2018/130199 A1 (BRAUER BJORN [US] ET AL) 10 May 2018 (2018-05-10) <br> * paragraph [0006] * <br> * paragraphs [0051] - [0053] * <br> * paragraph [0062] * <br> * paragraph [0070] * <br> * paragraph [0115] * | 3,5,10 | TECHNICAL FIELDS SEARCHED (IPC) <br> G03F G01N G06T |

The present search report has been drawn up for all claims

| Place of search | Date of completion of the search | Examiner |
|---|---|---|
| Munich | 24 February 2022 | van Toledo, Wiebo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 21 19 5866

This annex lists the patent family members relating to the patent documents cited in the above-mentioned European search report.
The members are as contained in the European Patent Office EDP file on
The European Patent Office is in no way liable for these particulars which are merely given for the purpose of information.

24-02-2022

| Patent document cited in search report | | Publication date | Patent family member(s) | | Publication date |
|---|---|---|---|---|---|
| US 2010142800 | A1 | 10-06-2010 | CN | 102210018 A | 05-10-2011 |
| | | | EP | 2374148 A2 | 12-10-2011 |
| | | | IL | 212096 A | 31-05-2015 |
| | | | JP | 5602146 B2 | 08-10-2014 |
| | | | JP | 2012511179 A | 17-05-2012 |
| | | | KR | 20110097878 A | 31-08-2011 |
| | | | US | 2010142800 A1 | 10-06-2010 |
| | | | WO | 2010065676 A2 | 10-06-2010 |
| US 2009016595 | A1 | 15-01-2009 | US | 2009016595 A1 | 15-01-2009 |
| | | | WO | 2008141064 A1 | 20-11-2008 |
| JP H09211840 | A | 15-08-1997 | NONE | | |
| US 2018130199 | A1 | 10-05-2018 | CN | 109964115 A | 02-07-2019 |
| | | | IL | 265905 A | 28-02-2021 |
| | | | KR | 20190069597 A | 19-06-2019 |
| | | | SG | 11201903715X A | 30-05-2019 |
| | | | TW | 201830134 A | 16-08-2018 |
| | | | US | 2018130199 A1 | 10-05-2018 |
| | | | WO | 2018089459 A1 | 17-05-2018 |

EPO FORM P0459

For more details about this annex : see Official Journal of the European Patent Office, No. 12/82

**EP 4 148 499 A1**

## REFERENCES CITED IN THE DESCRIPTION

**Patent documents cited in the description**

- US 5229872 A